# FASCICULE DE BREVET EUROPEEN

(11) **EP 2 647 053 B1**
(45) Date de publication et mention de la délivrance du brevet: **22.08.2018**
(21) Numéro de dépôt: 11788879.2
(22) Date de dépôt: 01.12.2011
(51) Int. Cl.: H01L 31/02

(54) **SYSTÈME D'ALIMENTATION ÉLECTRIQUE EN COURANT ET TENSION CONTINUS PROTÉGÉ PAR UN LIMITEUR EN COURANT ET SON PROCÉDÉ DE PROTECTION**
SYSTEM ZUR ZUFUHR VON GLEICHSTROM UND GLEICHSPANNUNG MIT SCHUTZ DURCH EINEN STROMBEGRENZER UND SCHUTZVERFAHREN DAFÜR
SYSTEM FOR SUPPLYING DIRECT CURRENT AND DC VOLTAGE PROTECTED BY A CURRENT LIMITER, AND METHOD FOR PROTECTING SAME

(30) Priorité: 02.12.2010 US 419012 P; 20.05.2011 FR 1154442
(43) Date de publication de la demande: 09.10.2013
(73) Titulaire: Mersen France SB SAS, 69720 Saint-Bonnet-de-Mure (FR)
(72) Inventeur: SARRUS, Franck, F-69720 Saint Laurent De Mure (FR); RAMBAUD, Thierry, F-69740 Genas (FR); TOURNIER, Dominique, F-69009 Lyon (FR); GODIGNON, Philippe, E-08197 Valldoreix (ES); DE PALMA, Jean-François, Arlington, Massachusetts 02476 (US)
(74) Mandataire: Lavoix
(86) Numéro de dépôt international: PCT/EP2011/071548
(87) Numéro de publication internationale: WO 2012/072759

(56) Documents cités:
- WO-A2-2011/032693
- FR-A1- 2 894 401
- US-A- 4 454 523

## Description

La présente invention concerne un système d'alimentation électrique à courant et tension continus avec un limiteur en courant pour le protéger contre des défauts de court-circuit interne de ses composants et un procédé de protection du système d'alimentation dans le cas de la survenue d'un tel défaut.

Des systèmes d'alimentation électrique à courant et tension continus comportant au moins deux branches d'alimentation électrique branchées en parallèle sont connus, dans lesquels, en fonctionnement normal, chaque branche d'alimentation électrique est un générateur de tension continue ayant une force électromotrice de même amplitude et orientée dans le même sens.

Un système d'alimentation électrique photovoltaïque est un exemple d'un tel système. Il comporte au moins deux chaînes photovoltaïques qui sont branchées en parallèle. Les chaînes photovoltaïques sont configurées pour fournir chacune, d'une part une force électromotrice de même amplitude en tension et polarisée dans un même sens, et, d'autre part un même courant de charge.

Les chaînes photovoltaïques sont formées chacune d'une série d'un même nombre de modules photovoltaïques, eux-mêmes étant des agencements identiques de cellules photovoltaïques. Les chaînes photovoltaïques sont branchées en parallèle et réalisent ainsi, lorsqu'elles fonctionnent normalement, un générateur de tension dont la tension de sortie est égale à la force électromotrice de l'une quelconque des chaînes photovoltaïques et dont le courant de charge est égal à la somme des courants de charge débités par les chaînes photovoltaïques.

Pour protéger l'alimentation électrique contre un court-circuit interne d'un ou plusieurs modules de l'une des chaînes d'alimentation, ou contre un évènement équivalent à un court circuit de ce type, il est connu de mettre en série, sur une chaîne d'alimentation susceptible de présenter un tel défaut, un fusible calibré de manière idoine pour le faire fondre en cas de défaut.

Il est également connu de mettre en série sur une chaîne d'alimentation susceptible de devenir défectueuse, un disjoncteur réglé de manière convenable pour réagir en cas de survenue d'un court-circuit interne sur la chaîne d'alimentation, le court-circuit pouvant s'accompagner le cas échéant d'une mise à la masse d'un ou plusieurs modules de le chaîne d'alimentation.

Un inconvénient de la solution utilisant le fusible est la nécessité d'une intervention manuelle pour remplacer le fusible. En outre dans le cas où le défaut est furtif, la remise en fonctionnement de la chaîne provisoirement défectueuse prend du temps en raison de la nécessité d'une intervention humaine.

Un inconvénient de la solution utilisant le disjoncteur est la nécessité d'un mécanisme de réarmement automatique encombrant et exigeant une source d'énergie externe. En outre, dans le cas d'un défaut furtif d'une courte durée, le temps de réarmement peut être long et on cherche à diminuer le temps du branchement à nouveau de la chaîne d'alimentation sur le système d'alimentation lorsque la chaîne est à nouveau dans un état normal de fonctionnement, c'est-à-dire dans un état sans défaut de court-circuit interne d'un ou plusieurs de ses modules.

Le document FR2894401 décrit un dispositif de contrôle d'une installation de production d'énergie électrique intégrant un interrupteur électrique. L'invention vise à remédier aux inconvénients décrits ci-dessus.

A cet effet l'invention a pour objet un système d'alimentation selon la revendication 1. Suivant des modes particuliers de réalisation, le système d'alimentation comporte l'une ou plusieurs des caractéristiques suivantes, prises seules ou en combinaison :
- la différence de tension entre la force électromotrice de la deuxième source de tension et la force électromotrice de la première source de tension défectueuse est supérieure ou égale à 20 volts.
- le rapport de la force électromotrice de la première source de tension défectueuse sur la force électromotrice de la deuxième source de tension est inférieur ou égal à 90%.
- le transistor de puissance est un transistor de type VJFET dont le substrat est en carbure de silice.
- le limiteur en courant comprend :
   le transistor de puissance à effet de champ ayant une électrode de drain, une électrode de source, et une électrode de grille de contrôle d'un courant de saturation,
   un capteur de courant image apte à fournir un courant image représentatif du courant de puissance traversant le canal de puissance du transistor de puissance,
   un capteur d'une température représentative d'une température régnant au sein du transistor de puissance,
   une unité de commande du limiteur en courant apte à commander le transistor de puissance en fonction de paramètres de mesures compris dans l'ensemble constitué par la température mesuré par le capteur de température et le courant image mesuré par le capteur de courant.
- le transistor de puissance comprend un ou plusieurs transistors de puissance élémentaires, chaque transistor élémentaire de puissance comprenant :
   un substrat d'un premier type de conductivité présentant une première face inférieure et une deuxième face supérieure,
   une électrode de drain en contact avec la première face inférieure du substrat,
   une première région semi-conductrice du premier type de conductivité présentant une deuxième face inférieure agencée sur la première face supérieure du substrat, et une deuxième face supérieure,
   une deuxième et une troisième région semi-conductrices d'un second type de conductivité, partiellement enterrées, agencées à l'intérieur de la première région semi-conductrice sous la deuxième face supérieure et délimitant à l'intérieur de la première région un canal vertical,
   une quatrième région semi-conductrice du premier type de conductivité, de grille de surface, recouvrant centralement, partiellement et respectivement une troisième face et une quatrième face supérieures des deuxième et troisième régions, la quatrième région formant un canal latéral,
   une cinquième région semi-conductrice du deuxième type de conductivité recouvrant centralement et partiellement une cinquième face de la quatrième région semi-conductrice,
   une première électrode de grille de commande disposée en surface de la cinquième région,
   au moins une zone de contact disposée sous la cinquième face dans une zone non recouverte par la cinquième région, et
   au moins une électrode de source disposée sur l'au moins une zone de contact, et
   une deuxième électrode de grille disposée soit sur une sixième face supérieure, soit sur une septième face supérieure dans une zone non recouverte par la quatrième région semi-conductrice.
- Le transistor de puissance comprend
   une deuxième électrode et une troisième électrode de grille disposées respectivement sur la cinquième face supérieure et la sixième face supérieure dans des zones non recouvertes par la quatrième région semi-conductrice,
   les deux zones de contacts, disposées de part et d'autre du canal vertical, sous la quatrième face supérieure dans des zones non recouverte par la cinquième région,
   deux électrodes de sources disposées chacune sur une zone de contact différente.
- la deuxième électrode de grille est disposée sur la deuxième région semi-conductrice, le transistor de puissance comprend une seule électrode de source et une unique zone de contact de l'électrode de source, et l'électrode de source d'un seul tenant recouvre à la fois la zone de contact et une zone de la troisième région semi-conductrice non recouverte par la quatrième région semi-conductrice.

L'invention a également pour objet un procédé de protection d'un système d'alimentation électrique selon la revendication 9. Suivant des modes particuliers de réalisation, le procédé de protection du système d'alimentation comporte l'une ou plusieurs des caractéristiques suivantes, prises seules ou en combinaison :
- le transistor de puissance à effet de champ ayant une électrode de drain, une électrode de source, et une électrode de grille de contrôle du courant de saturation,
- un capteur de courant image apte à fournir un courant image représentatif du courant de puissance traversant le canal de puissance du transistor de puissance,
- une unité de commande du limiteur en courant apte à commander le transistor de puissance en fonction de du courant image mesuré par le capteur de courant, et dans lequel
- dans la première étape la grille du transistor de puissance est mise à une première valeur de tension de commande de référence, et
- dans lequel le procédé comprend une étape, antérieure à la deuxième étape et postérieure à la première étape, dans laquelle
- le capteur de courant image mesure un courant représentatif du courant de puissance traversant le transistor de puissance,
- lorsqu'un défaut a lieu sur la première branche d'alimentation, le courant de puissance et le courant image inversent leur sens et lorsque le courant image dépasse une première valeur de seuil de déclenchement, l'unité de commande envoie une commande de mise de la tension de la grille du transistor de puissance à une deuxième valeur de tension de grille de façon à régler une deuxième valeur de saturation du courant de puissance,
- lorsque la première branche d'alimentation fonctionne normalement, la tension de commande de la grille reste à la première valeur de commande et le transistor de puissance (58) fonctionne dans la première zone.
- le limiteur de courant comprend en outre
- un capteur d'une température représentative d'une température régnant au sein du transistor de puissance,
- et l'unité de commande du limiteur en courant est apte à commander le transistor de puissance en fonction de paramètres de mesures compris dans l'ensemble constitué par la température mesurée par le capteur de température et le courant image mesuré par le capteur de courant, et
- dans l'étape, le capteur de température mesure la température et le capteur de courant mesure le courant image,
- lorsqu'un défaut a lieu sur la première source de tension de la première branche d'alimentation, le courant de puissance et le courant image inversent leur sens et lorsque la température dépasse en croissant une première valeur de seuil de déclenchement en température et/ou lorsque le courant image dépasse en croissant une première valeur de seuil de déclenchement en courant image, l'unité de commande envoie une commande de mise de la tension de la grille du transistor de puissance à une valeur de tension de commande conservative par rapport à l'état de dépassement du couple formé par le premier seuil de déclenchement en courant image et le premier seuil de déclenchement en température,
- la valeur de tension de commande conservative étant la valeur de tension parmi la deuxième et la troisième valeur de tension de commande qui correspond à une valeur de courant de saturation le plus petit lorsque le premier seul de déclenchement en courant image et lorsque le premier seul de déclenchement en température sont dépassés, .
- la valeur de la tension de commande conservative étant égale à la deuxième valeur de tension de commande lorsque seul le premier seuil de déclenchement en courant image est dépassé,
- la valeur de la tension de commande conservative étant égale à la troisième valeur de tension de commande lorsque seul le premier seuil de déclenchement en température est dépassé.
- Lorsque aucun courant ne circule dans le transistor de puissance et que le capteur de courant en fournit une valeur image correspondant à un biais, le capteur de température poursuit la surveillance du courant image, et
- lorsqu'une inversion du courant est détectée par le capteur de courant représentative d'un basculement d'un fonctionnement du limiteur depuis la première zone dans la deuxième zone, la tension de commande d'inhibition complète de circulation du courant de puissance dans le transistor de puissance est supprimée.

L'invention sera mieux comprise à la lecture de la description de plusieurs formes de réalisation qui vont suivre, données à titre d'exemples et faites en se référant aux dessins dans lesquels :
- la Figure 1 est une vue d'un système d'alimentation photovoltaïque selon l'invention qui alimente en fonctionnement normal une charge électrique ;
- la Figure 2 est une vue de la courbe d'évolution du courant en fonction de la tension aux bornes d'un transistor de puissance d'un limiteur en courant intégré dans l'une des branches du système d'alimentation de la Figure 1,
- la Figure 3 est une vue du système d'alimentation photovoltaïque de la Figure 1 dans le cas d'une première configuration de défaut d'une chaîne d'alimentation ;
- la Figure 4 est une vue du système d'alimentation photovoltaïque de la Figure 1 dans le cas d'une deuxième configuration de défaut d'une chaîne d'alimentation ;
- la Figure 5 une vue d'un système d'alimentation électrique selon l'invention généralisant le système photovoltaïque représenté à la figure 1 ;
- la Figure 6 est un schéma électrique d'un limiteur en courant selon l'invention, intégré dans une branche d'alimentation du système d'alimentation des Figures 1 et 5 ;
- la Figure 7 montre des courbes caractéristiques d'évolution du courant de drain du transistor de puissance formant en partie le limiteur en courant de la Figure 6, en fonction de la tension différentielle drain-source du transistor de puissance pour diverses valeurs de sa tension de grille ;
- la Figure 8 représente l'évolution de la tension de la commande de la grille du transistor de puissance en fonction seulement du courant image capté par le capteur de courant image ;
- la Figure 9 représente l'évolution de la tension de la commande de la grille du transistor de puissance en fonction seulement de la température, captée par le capteur de température ;
- la Figure 10 est une vue de dessus d'extensions latérales d'un composant électronique intégré multicouches formant le limiteur en courant de la Figure 6 et intégrant ses diverses fonctions ;
- la Figure 11 est une vue en élévation des couches d'une première forme de réalisation d'un transistor de puissance élémentaire du composant électronique intégré de la Figure 10 ;
- la Figure 12 est une vue en élévation des couches d'une deuxième forme de réalisation d'un transistor de puissance élémentaire du composant électronique intégré de la Figure 10 ;
- la Figure 13 est une vue en élévation des couches d'un capteur de température du composant électronique de la Figure 10 ;
- la Figure 14 est un ordinogramme d'un procédé de protection du système d'alimentation des Figures 1 et 5 ;
- la figure 15 représente l'évolution temporelle de paramètres caractéristiques compris dans l'ensemble formé par le courant de puissance du transistor de puissance, le courant image capté, la température, la tension de commande de la grille du transistor de puissance dans le cas d'une séquence particulière de fonctionnement du système d'alimentation de la Figure 1.

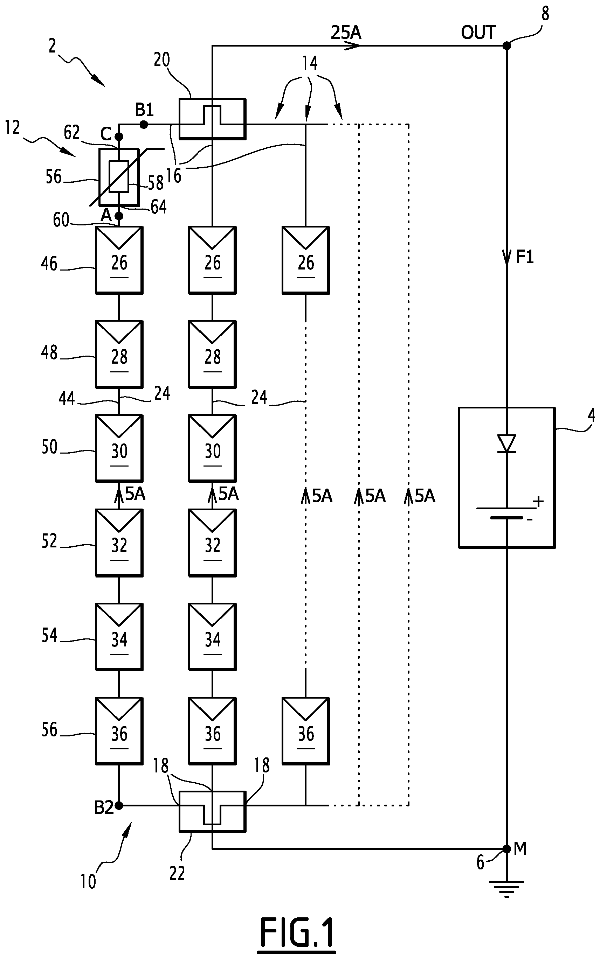

Suivant la Figure 1, un système d'alimentation électrique photovoltaïque 2 à tension et courant continus est raccordé à une charge électrique 4, par exemple un onduleur électrique suivi en aval d'un réseau de charges, au travers d'une première borne de masse 6 sous une tension de référence, ici égale à zéro volt, et d'une deuxième borne de sortie 8 sous une tension positive désignée par Vs, ici prise égale à 600 volts.

Le système d'alimentation photovoltaïque 2 est configuré pour fournir en sortie à la charge 4 une tension électrique stable, indépendante d'une variation éventuelle de charge de la charge électrique 4.

Lorsqu'il fonctionne normalement, le système d'alimentation photovoltaïque 2 est configuré pour fournir en sortie une tension d'amplitude égale à 600 volts et un courant continu d'intensité nominale égale à 25 A.

Le système d'alimentation électrique 2 comprend un ensemble 10 de branches d'alimentation 12, 14 connectées en parallèle, ici cinq branches dont seules deux 12, 14 sont représentées complètement sur la Figure 1, chaque banche 12, 14 ayant une première extrémité 16 et une deuxième extrémité 18.

Le système d'alimentation électrique 2 comprend un premier boîtier de jonction 20, respectivement un deuxième boîtier de jonction 22, configurés pour raccorder entre elles et aux bornes 6 et 8 les premières extrémités 16 des branches 12, 14, respectivement les deuxièmes extrémités 18 des branches 12, 14.

Chaque branche d'alimentation 12, 14 comprend un ensemble ayant une même structure 24 de six modules d'alimentation électrique 26, 28, 30, 32, 34, 36 banchés en série. Un ensemble quelconque 24 de modules d'alimentation est appelé chaîne (en anglais « string ») de modules.

Au moins l'une des banches, ici la branche désignée par la référence 12 sur la Figure 1, et dans la suite de la description dénommée la première branche 12, est susceptible de rencontrer un défaut de fonctionnement au cours de sa vie.

Le défaut de fonctionnement d'une branche d'alimentation est typiquement la mise en court-circuit interne d'un ou plusieurs des modules de sa chaîne.

Le défaut peut également être l'équivalent d'un court circuit interne d'un ou plusieurs modules, comme par exemple l'ombrage par un nuage privant un ou plusieurs modules d'éclairement par le soleil. La chaîne contenant ces modules ombrés possède alors une force électromotrice plus faible que les autres chaînes d'alimentation. Elle se comporte alors comme un récepteur qui voit sa tension et son courant inversés en même temps.

Dans la suite de la description, pour distinguer les éléments formant la première branche d'alimentation 12 des autres branches d'alimentation 14, la chaîne 24 de modules, les modules 26, 28, 30, 32, 34, 36 de la première branche 12 sont respectivement désignés par les références 44, 46, 48, 50, 52, 54, 56.

La première chaîne 12 comprend un limiteur en courant 56 ayant une transistor de puissance 58 à effet de champ FET (en anglais Field Effect Transistor), branché en série entre la première extrémité 16 de la première branche 12 et une extrémité 60 de la chaîne 44, formant une première borne d'entrée du module 46.

Le limiteur de courant 56 comprend une première borne 62 de puissance et une deuxième borne 64 de puissance, la première borne 62 étant connectée au premier boîtier de jonction 20 au travers de la première extrémité 16 de la première branche 12, la deuxième borne 64 étant connectée à la première borne 60 du module 46 formant le premier module d'extrémité de la première chaîne 44.

En fonctionnement normal, chaque module d'alimentation 26, 28, 30, 32, 34, 36, 46, 48, 50, 52, 54, 56 est une source de tension élémentaire et comprend un arrangement de cellules photovoltaïques non décrit en détail ici.

Par exemple, la source de tension élémentaire d'un module d'alimentation est une source de tension, ayant un force électromotrice égale à +100 Volts, et apte à débiter en fonctionnement normal un courant nominal de 5 ampères.

Chaque branche d'alimentation 12, 14 en fonctionnement normal est une source de tension de force électromotrice égale à +600 volts et configurée pour fournir un courant nominal de 5 A.

Les branches d'alimentation 12, 14 sont branchées en parallèle et leurs forces électromotrices sont orientées dans le même sens de sorte que le système d'alimentation 2 est configuré pour fournir, en fonctionnement normal, un courant continu nominal de 25 A sous une tension continue de 600 volts.

Des sens de courants sont représentés sur la Figure 1 accompagnant des valeurs d'intensité de courant 5 A et 25 A. Par convention, les sens des courants d'intensité 5 A sont négatifs lorsque ces courants sont entrants dans le boitier de jonction 20.

Si M désigne un point de référence de la première borne 6 de mise à la masse du système d'alimentation 2 et OUT désigne un point de la deuxième borne de sortie 8 d'alimentation d'application de la tension de sortie positive Vs, le courant qui traverse la charge 4 est dirigé depuis le point OUT vers le point M suivant le sens d'une flèche F1.

Si B1 désigne un point de la première extrémité 16 de la première banche 12, et B2 un point de la deuxième extrémité 18 de la première branche 12, en fonctionnement normal les tensions appliquées et observées en ces deux points sont respectivement égales à +600 volts et 0 Volt.

De même les tensions appliquées et observées aux premières extrémités 16 et aux deuxièmes extrémités 18 des autres branches 14 d'alimentation sont respectivement égales à +600 volts et 0 Volt.

En fonctionnement normal, la tension appliquée au point A à la deuxième borne 64 du limiteur 56 est légèrement supérieure à 600 Volts, ici égale à 601 Volts, de manière à compenser la chute de tension dans la première branche 12 provoquée par le limiteur en courant 56, la chute de tension étant ici égale à 1 Volt pour un courant nominal de 5 A.

Le limiteur en courant 56 est branché comme un dipôle électrique, en série au travers de sa première borne 62 et de sa deuxième borne 64, par rapport à la source de tension formée par la première chaîne 44 des modules 46, 48, 50, 52, 54, 56.

Pour simplifier les notations, un point A désigne un point de la deuxième borne 64 sous une tension V_{A} et un point C désigne un point de la première borne 62 sous une tension V_{C}. La tension électrique différentielle du limiteur en courant 56 est la différence entre la tension observée à la première borne 62 et la tension observée à la deuxième borne 64, et elle est notée V_{AC}, avec V_{AC} égale à V_{C} moins V_{A}.

Le limiteur en courant 56 possède une caractéristique d'évolution du courant électrique, désigné par I, traversant le dispositif de limitation de courant en fonction de la tension électrique entre les deux bornes de connexion V_{AC}.

Dans la définition de cette caractéristique, par convention le sens du courant est positif lorsque le courant traverse le limiteur de C vers A.

La courbe caractéristique d'évolution courant(I)/tension(V_{AC}) comprend une première zone, de conduction inverse, dans laquelle la tension électrique et le courant sont de même sens et négatifs, et le courant sans limitation lorsque la tension V_{AC} décroît, c'est-à-dire croit dans le sens des valeur négatives, et une deuxième zone, de conduction directe, dans laquelle la tension électrique V_{AC} et le courant électrique I traversant le limiteur de courant sont de même sens et sont positifs, et dans laquelle le courant électrique est limité à partir d'un seuil en courant.

En variante, la première zone comprend une sous-zone dans laquelle la pente de la caractéristique courant/tension, c'est-à-dire la conductance, est de même signe et de même amplitude qu'une pente moyenne de la deuxième zone de la courbe caractéristique avant la limitation du courant.

La première zone est inscrite dans un troisième quadrant, noté quadrant Q3, défini par le demi-axe de courant négatif et le demi-axe de tension négatif.

La deuxième zone est inscrite dans un quadrant appelé premier quadrant, noté quadrant Q1, défini par le demi-axe de courant positif et le demi-axe de tension positif V_{AC}.

Le limiteur en courant 56 est connecté à la source de tension de la première branche 12 en inverse de la force électromotrice de la première branche d'alimentation 12, de sorte que, lorsque la première branche 12 fonctionne normalement, c'est-à-dire en générateur, le courant I traverse le limiteur de A vers C en étant de sens négatif et la tension différentielle V_{AC} aux bornes du limiteur, V_{C} moins V_{A} est négative.

Ainsi, le limiteur en courant fonctionne dans la première zone lorsque la première branche 12 fonctionne normalement et dans la deuxième zone lorsqu'un défaut de court circuit interne a lieu sur la première branche 12.

Lorsque la première branche fonctionne normalement, la tension V_{A} est égale à +601 volts, et un courant nominal de 5 A traverse de A vers C le limiteur en courant 56 qui fonctionne dans la première zone inscrite dans le troisième quadrant.

Ce courant négatif avec les conventions de signes de la caractéristique courant/tension entraîne une chute de tension aux bornes du limiteur 56, V_{AC} égale à +1 volt, ce qui entraîne que la tension V_{C} est égale à 600 Volts.

Le transistor de puissance à effet de champ 58 est unipolaire, c'est-à-dire unidirectionnel en limitation de courant. Ici, le transistor de puissance 58 est de type à canal N, c'est-à-dire possède une jonction semi-conductrice dopée par des charges électriques négatives.

Le transistor de puissance à effet de champ 58 est un transistor à effet de champ compris dans les transistors à effet de champ à jonction (en anglais Junction Field Effect Transistor JFET) et dans les transistors à effet de champ de type MOS (en anglais Metal Oxyde Silicon Field Effect Transistor MOSFET).

De préférence, le transistor de puissance à effet de champ est un transistor à effet de champ à jonction (JFET), encore appelé un transistor à effet de champ par jonction de type grille (JUGFET pour Junction Gâte Field Effect Transistor).

De manière encore préférée, le transistor de puissance à effet de champ est un transistor à effet de champ à jonction verticale (VJFET pour Vertical Junction FET).

En variante, le limiteur en courant 56 comporte un transistor de puissance à effet de champ de type à canal P, c'est-à-dire ayant une jonction semi-conductrice dopée par des charges électriques positives ou trous. Dans ce cas le transistor est intégré de manière adaptée dans le système d'alimentation.

Le substrat semi-conducteur de base du transistor de puissance 58 est un matériau compris dans le silicium et le carbure de silicium.

De manière préférée, le matériau du substrat semi-conducteur est du carbure de silice.

De manière générale, le matériau du substrat semi-conducteur est un matériau à large bande interdite comme par exemple le silicium, le carbure de silicium, le nitrure de gallium GaN et le diamant.

De manière préférée, le limiteur en courant 56 comporte un transistor de puissance à effet de champ 58 à jonction verticale (VJFET) avec un canal de type N et une jonction de grille de type P.

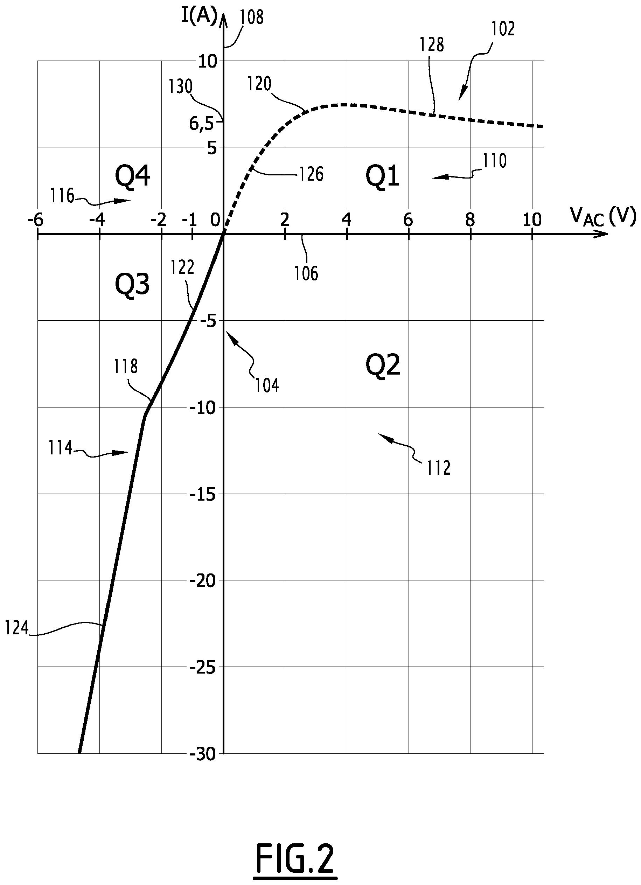

Suivant la Figure 2, une caractéristique 102 d'évolution courant/tension V_{AC} d'un VJFET est représentée, le transistor VJFET étant configuré pour fonctionner intégré dans le système d'alimentation 2 de la Figure 1.

La caractéristique 102 d'évolution du courant I en fonction de la différence de tension V_{AC} aux bornes du limiteur est représentée dans un repère 104 ayant, en axe des abscisses, un premier axe 106 de tensions V_{AC} dont l'unité est exprimées en volt, et en axe des ordonnées, un deuxième axe 108 de courant I dont l'unité est exprimée en ampère.

Le repère comprend quatre quadrants, un premier 110, un deuxième 112, un troisième 114, un quatrième quadrant 116, désignés respectivement sur la Figure 2 par les références Q1, Q2, Q3 et Q4.

Le premier quadrant Q1 est délimité par le demi-axe de courant positif et le demi-axe de tension positif.

Le deuxième quadrant Q2 est délimité par le demi-axe de courant négatif et le demi-axe de tension positive.

Le troisième quadrant Q3 est délimité par le demi-axe de courant négatif et le demi-axe de tension négative.

Le quatrième quadrant Q4 est délimité par le demi-axe de courant positif et le demi-axe de tension négative.

La caractéristique d'évolution 102 courant/tension est ici une courbe comprenant une première zone 118 de courbe, inscrite dans le troisième quadrant Q3 et représentative du régime en polarisation inverse d'un VJFET à canal de type N, et une deuxième zone de courbe 120, raccordée continûment à le première zone 118 de courbe en l'origine du repère 104, inscrite dans le premier quadrant Q1 et représentative du régime en polarisation directe du VJFET à canal de type N.

Ici, la caractéristique d'évolution 102 est représentée pour une tension de grille fixée à une valeur prédéterminée, l'allure ou la forme des variations étant indépendantes de la valeur de la tension de grille du transistor VJFET.

La première zone 118 de la courbe d'évolution ne présente pas de limitation en courant en régime de polarisation inverse.

En polarisation inverse, le JFET est assimilable de manière approchée à une première résistance R1 lorsque la polarisation inverse est faible, ici supérieure à -3 Volts, et à la première résistance placée en parallèle avec une diode D1 sous un régime de forte injection lorsque la polarisation inverse est forte, ici V_{AC} inférieure à -3 volts.

Ici, la valeur de - 3 Volts correspond à un JFET dont le substrat semi-conducteur est en carbure de silicium. Lorsque le substrat semi-conducteur du JFET est du silicium cette valeur est égale à -0,7 Volt.

La diode D1 est la diode formée par la jonction source de type P - canal dopé N du transistor de puissance 58 VJFET et sa résistance, désignée par une deuxième résistance R2 possède une valeur nettement plus faible que celle de la première résistance R1, d'au moins dix en ordre de grandeur.

Ainsi, la première zone 118 comprend une première sous-zone 122 de profil linéaire pour V_{AC} ici comprise entre -3 Volts et 0 avec une première pente de conductance, et une deuxième sous-zone 124 pour V_{AC} inférieur à -3 Volts avec une deuxième pente de conductance, la deuxième pente étant au mois 10 fois plus grande que la première pente.

Le transistor de puissance 58 VJFET est configuré et dimensionné de sorte que le rapport de la puissance dissipée par le limiteur 56 placé dans son point de fonctionnement, ici -1 volts et -5 A, sur la puissance délivrée par la branche d'alimentation 12 dans laquelle le limiteur est monté en série est inférieur à une valeur prédéterminée. Ici à titre d'exemple, ce rapport des puissances est égal à 5/3000.

En polarisation directe, le transistor VJFET 58 est assimilable à un limiteur classique et la deuxième zone 120 comprend successivement une première sous-zone 126 et une deuxième sous-zone 128 ayant chacune respectivement une première pente et une deuxième pente.

La première sous-zone 126 est une zone de conduction en polarisation directe pour laquelle la première pente de conductance est sensiblement égale à la première pente de conductance de la première sous-zone 122 de la première zone 118 correspondant au régime en polarisation inverse.

La deuxième sous-zone 128 est une zone de limitation en courant qui est effective à partir d'un seuil de courant de limitation 130 dont la valeur est ici égale à 1,3 fois la valeur du courant nominal de la première branche d'alimentation lorsque cette dernière fonctionne normalement, c'est-à-dire égal à 6,5 A.

Ainsi la première sous-zone 126 et la deuxième sous-zone 128 sont définies respectivement pour des valeurs de courant comprises entre 0 et 6,5 A et pour des valeurs supérieures à 6,5 A et inférieures à un courant pic.

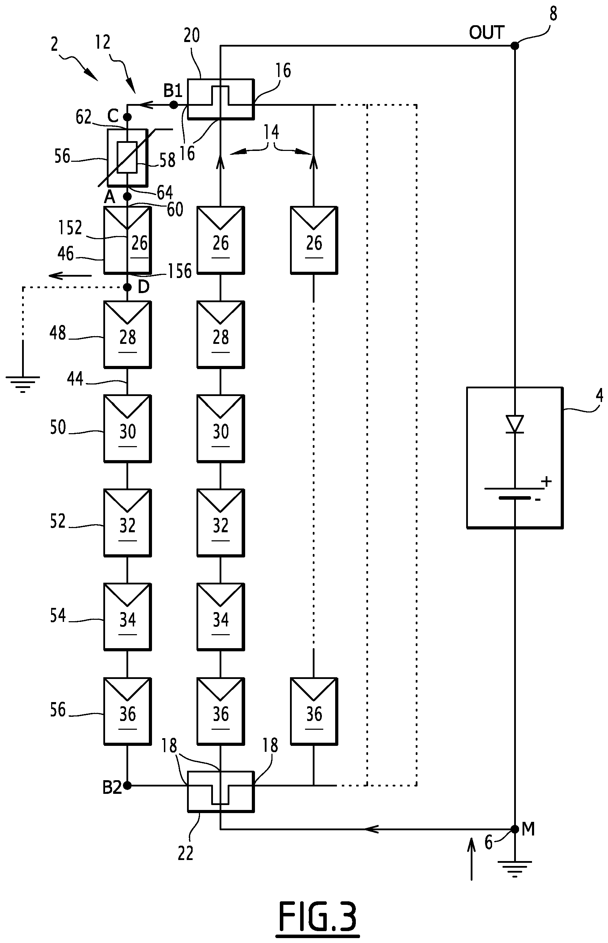

Suivant la Figure 3, une première configuration de défaut de la première branche 12 est représentée dans laquelle un court-circuit interne du module 46 a lieu avec une mise à la masse de ce module.

La première branche d'alimentation 12 fonctionne alors comme un récepteur soumis à la tension Vs des autres branches d'alimentation 14, ici de 600 Volts, en sa première extrémité 16, c'est-à-dire au point B1. Les autres branches d'alimentation 14 branchées en parallèle sont équivalentes ensemble à un unique générateur de tension vis à vis de la première branche 12, l'impédance de sortie de ce générateur étant égale à l'impédance de sortie de la première branche d'alimentation 12 fonctionnant en récepteur et étant indépendante de la charge 4 du réseau.

Le court-circuit du module 46 est représenté sur la Figure 3 par une liaison filaire 152 parfaitement conductrice reliant les deux bornes d'extrémité de connexion du module 46.

La tension V_{A}, observée à la première borne 60 d'extrémité du module 46 reliée à la deuxième borne 64 du limiteur 58, est alors la même que la tension V_{D}, appliquée en un point D à une deuxième borne 156 d'extrémité du module 46, reliée en série à la chaîne des modules non défectueux 48, 50, 52, 54, 56, la tension V_{D} étant égale à +500 Volts.

La tension V_{C} observée à la première borne 62 du limiteur de courant 58 est égale à la tension Vs des premières extrémités 16 des autres branches d'alimentation 14, c'est-à-dire à la tension V_{B} et elle est égale à +600 Volts.

La différence de tension V_{AC} appliquée entre la première borne 62 et la deuxième borne 64 est alors positive et égale +100 Volts et change de signe par rapport à la tension observée aux bornes du limiteur 56 lorsque la première branche fonctionne normalement.

Le limiteur en courant 56 fonctionne alors dans la deuxième zone 120 de sa caractéristique en mode de limitation de courant, c'est à dire dans le premier quadrant 110.

Le courant qui traverse le limiteur 56 croit jusqu'à atteindre et dépasser la valeur de seuil de 130 limitation en courant, ici égale à 6,5 A, pour être atténué ensuite dans la deuxième sous-zone 128 de la deuxième zone 120.

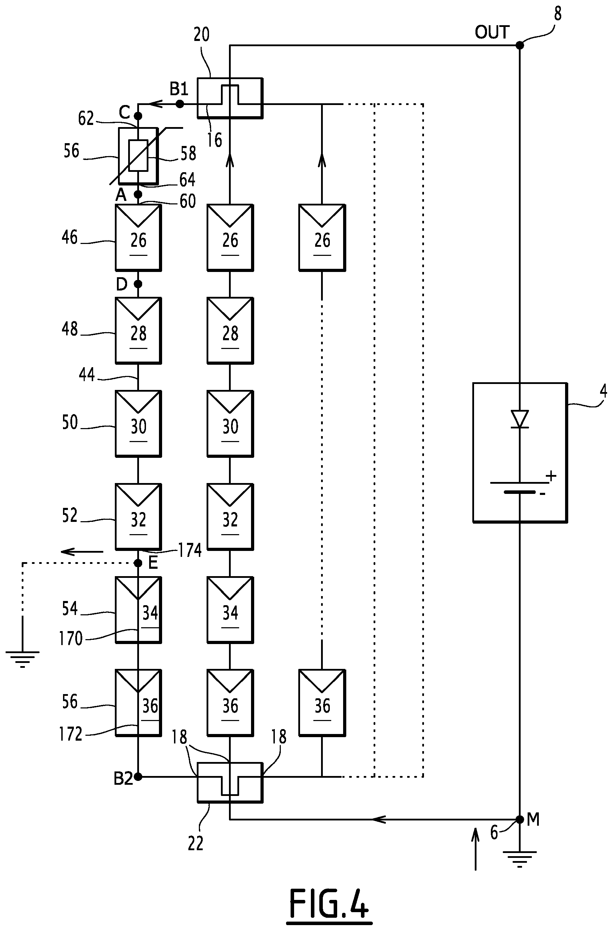

Suivant la Figure 4, une deuxième configuration de défaut de la première branche 12 est représentée dans laquelle un court-circuit interne des deux modules 54 et 56 de la première branche d'alimentation 12 branchés directement en série a lieu avec un mise à la masse des deux modules 54, 56.

Le court circuit des deux modules 54, 56 est représenté sur la Figure 4 par deux liaisons filaires 170, 172 parfaitement conductrices traversant respectivement part en part les deux modules 54, 58.

La première branche d'alimentation 12 fonctionne alors comme un récepteur soumis à la tension V_{S} des autres branches d'alimentation 14, ici de +600 volts, en sa première extrémité 16, c'est-à-dire au point B1. Les autres branches d'alimentation 14, branchées en parallèle, sont équivalentes ensemble à un unique générateur de tension vis-à-vis de la première branche 12, l'impédance de sortie vue par ce générateur étant égale à l'impédance de sortie de la première branche d'alimentation 12 fonctionnant en récepteur et étant indépendante de la charge 4 du réseau.

La tension V_{E}, observée au point E en une borne 174 d'extrémité de la chaîne des quatre modules 46, 48, 50, 52 qui se trouvent en état de fonctionnement normal, la borne 174 étant reliée au module 54 défectueux, est égale à la tension V_{M} du point M de référence à la masse 6, c'est-à-dire 0 Volt, en raison des courts-circuits des modules 54, 56 montés en série.

La tension V_{A} appliquée et observée à la deuxième borne 64 du limiteur de courant 58 est alors égale à +400 Volts.

La tension V_{C} appliquée à la première borne du limiteur de courant 58 est égale à la tension Vs des premières extrémités 16 des autres branches d'alimentation 14, c'est-à-dire à +600 Volts.

La différence de tension V_{AC} appliquée entre la première borne et la deuxième borne est alors positive et égale +200 Volts et change de signe par rapport à la tension observée aux bornes du limiteur 56 lorsque la première branche 12 fonctionne normalement.

Le limiteur de courant 56 fonctionne alors dans la deuxième zone 120 de sa caractéristique dans le mode de limitation en courant, c'es à dire dans le premier quadrant Q1.

Le courant qui traverse le limiteur 56 croit jusqu'à atteindre et dépasser la valeur de seuil 130 de limitation en courant, ici égale à 6,5 A, pour être atténué ensuite dans la deuxième sous-zone 128 de la deuxième zone 120.

Il est à remarquer que l'analyse décrite pour les Figures 3 et 4 est applicable à un défaut quelconque survenant sur un ou plusieurs modules de la première chaîne d'alimentation 12.

Dans tous ces cas de défaut, le limiteur en courant 56 est soumis à la fois à une inversion de la tension et du courant à ses bornes, le faisant passer d'une zone de fonctionnement sans limitation en courant contenue dans le troisième quadrant Q3 à une zone de fonctionnement avec limitation en courant contenue dans le premier quadrant Q1.

Dans le cas d'un défaut temporaire ou furtif, lorsque le défaut a disparu, c'est-à-dire lorsque la première branche d'alimentation 12 retrouve sa capacité entière à fonctionner en source de tension, c'est-à-dire est apte à fournir une tension de 601 Volt, le limiteur de courant 58 est soumis à une inversion dans l'autre sens à la fois de la tension et du courant à ses bornes, le faisant passer d'une zone de fonctionnement avec limitation en courant en premier quadrant Q1 à une zone de fonctionnement sans limitation en troisième quadrant Q3.

Il est rappelé que lorsque le limiteur est un transistor JFET à canal N, le premier quadrant Q1 correspond à une polarisation en direct du transistor de puissance et le troisième quadrant III correspond à une polarisation en inverse.

Ainsi, avantageusement, sans intervention manuelle, le limiteur de courant 58 commute automatiquement d'un mode de fonctionnement normal en conduction inverse à un mode de fonctionnement de protection de la première chaîne d'alimentation défectueuse en conduction directe, et inversement si le défaut est un défaut temporaire.

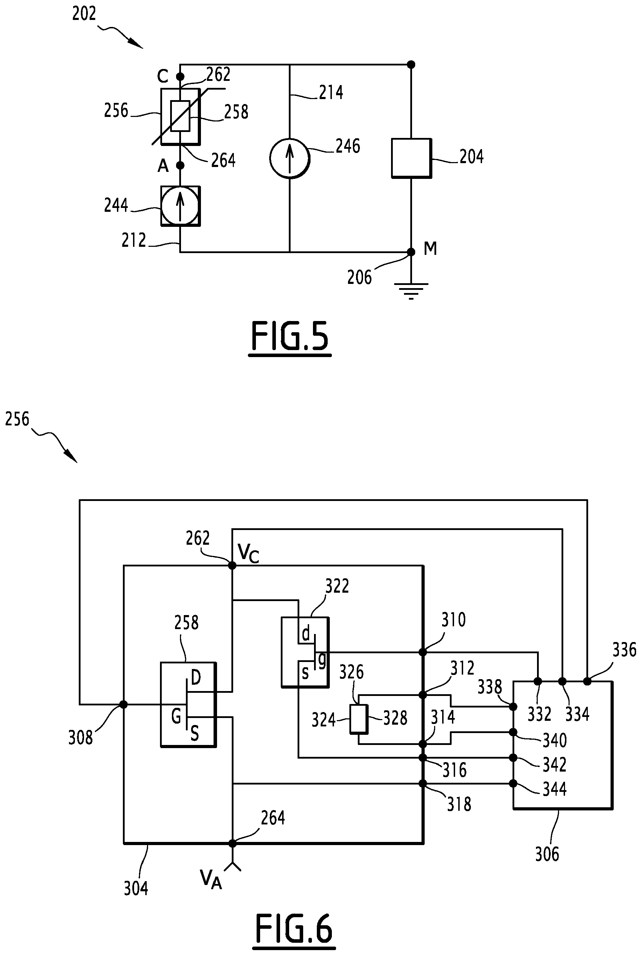

Suivant la Figure 5, une généralisation du système d'alimentation photovoltaïque est proposée dans laquelle un système d'alimentation électrique 202 est configuré pour alimenter en courant continu sous une tension continue nominale prédéterminée une charge électrique 204 équivalente à l'ensemble d'un réseau à alimenter.

La charge électrique 204 de réseau a une impédance prédéterminée sous la tension d'alimentation nominale lorsqu'elle reçoit un courant continu de charge d'alimentation nominal prédéterminé.

Le système d'alimentation électrique 202 comprend une première branche d'alimentation électrique 212 et une deuxième branche d'alimentation électrique 214 connectées en parallèle sur la charge électrique 204.

La première banche d'alimentation 212 comporte connectés en série une première source de tension 244 et un limiteur en courant 256.

Le limiteur en courant 256 comporte un transistor de puissance à effet de champ 258, configuré pour limiter le courant dans un sens.

La deuxième branche d'alimentation 214 comporte une deuxième source de tension 246.

Les sources de tension 244, 246 des deux branches d'alimentation 212, 214 sont polarisées dans une même sens et ont, chacune, lorsqu'elles fonctionnent toutes deux normalement, une même force électromotrice égale sensiblement à la tension d'alimentation nominale prédéterminée de la source d'alimentation.

Le transistor de puissance à effet de champ 258, branché en série à la première source de tension 244, forme un dipôle électrique.

Le transistor de puissance à effet de champ 258 a une première borne 262 de connexion reliée à la charge 204 et une deuxième borne de connexion 264 reliée à la première source de tension 244.

Le transistor de puissance à effet de champ 258 est configuré selon une caractéristique d'évolution du courant le traversant en fonction de la tension différentielle électrique entre ses bornes 262, 264, la tension différentielle étant définie comme la tension appliquée à la première borne 262 moins la tension appliquée à la deuxième borne 264, et le sens du courant étant positif lorsqu'il circule depuis la première borne 262 vers la deuxième borne 264.

La caractéristique d'évolution du courant en fonction de la tension différentielle du transistor de puissance à effet de champ 258 comprend une première zone, en polarisation inverse, dans laquelle la tension électrique différentielle et le courant électrique ont le même sens et sont négatifs, et le courant est dépourvu de limitation.

La caractéristique du transistor de puissance à effet de champ 258 comprend une deuxième zone, en conduction directe, dans laquelle la tension différentielle électrique et le courant sont de même sens et positifs, et le courant électrique est limité à partir d'une valeur de seuil de courant.

Le transistor de puissance à effet de champ 258 est connecté à la première source de tension 244 sous une polarisation inverse de sorte que la tension différentielle du transistor à effet de champ 258 et la force électromotrice de la première source 244 de tension lorsque la première branche d'alimentation 212 fonctionne normalement sont opposées.

La première branche d'alimentation 212 est configurée de sorte que, lorsqu'un défaut a lieu sur la première source tension 244, la force électromotrice de la première source de tension 244 est inférieure à la force électromotrice de la seconde source de tension 246, et la première branche d'alimentation 212 fonctionne en récepteur vis-à-vis de la deuxième branche d'alimentation.

Lorsqu'un défaut survient sur la première source de tension 244, le transistor de puissance à effet de champ 258 fonctionne dans la deuxième zone et limite le courant lorsque ce dernier dépasse la valeur de seuil. Ainsi, le transistor de puissance à effet de champ 258 protège la première branche d'alimentation 212 en cas de défaut sur la première source. Le transistor 258 protège également le système d'alimentation 202 dans sa totalité, par exemple en évitant un effet de destruction thermique qui se propage.

De manière préférée, la différence de tension entre la force électromotrice de la deuxième source de tension 246 et la force électromotrice de la première source de tension 244 défectueuse est au moins supérieure ou égale à 20 volts.

De manière préférée, le rapport de la tension de la première source de tension 244 défectueuse sur la tension de la deuxième source de tension 246 est au moins inférieur ou égal à 90%.

Par la suite, les limiteurs en courant 56 et 256 sont supposés identiques.

Suivant la Figure 6, le limiteur en courant 256 comprend un composant électronique intégré de limiteur 304 et une unité de commande 306 du limiteur.

Le composant intégré de limiteur 304 comprend la première borne 262 et la deuxième borne 264 de connexion du limiteur 256 qui sont les bornes au travers desquelles circule le courant de puissance d'alimentation de la première branche d'alimentation 212.

Le composant intégré de limiteur 304 comprend une troisième borne d'entrée 308, apte à recevoir une commande d'un seuil de limitation du courant de puissance, et une quatrième borne d'entrée 310 de réglage du gain de capture d'un courant image.

Le composant intégré de limiteur 304 comprend une cinquième borne 312 d'entrée et une sixième borne 314 de sortie d'un courant représentatif d'une température T régnant au sein du composant électronique intégré du limiteur 304.

Le composant intégré de limiteur 304 comprend une septième borne d'entrée 316 d'entrée et une huitième borne 318 de sortie d'un courant image, représentatif du courant de puissance traversant les bornes de connexion 262, 264 du transistor de puissance 258, ce dernier étant branché dans la Figure 5 à la première source de tension 244 de la première branche d'alimentation 212.

Le composant intégré de limiteur 304 comprend le transistor à effet de champ de puissance 258, un capteur de courant image 322, et un capteur de température 324.

Le transistor de puissance à effet de champ de puissance 258 comporte une électrode de drain D, une électrode de source S, et une électrode de grille G de contrôle du courant de saturation du transistor, c'est-à-dire le courant de limitation de la première branche défectueuse 212. L'électrode de grille G, l'électrode de drain D, l'électrode de source S du transistor de puissance 258 sont connectées respectivement à la troisième borne d'entrée 308 de réception de la commande du seuil de limitation en courant, et aux bornes de connexion 262, 264 de puissance.

Le capteur de courant 322 est apte à fournir un courant image, représentatif du courant traversant le transistor de puissance 258 entre l'électrode de source S et l'électrode de drain D. Le capteur de courant 322 est un transistor de type JFET, couplé électriquement au transistor de puissance 258, et possède une grille g, un drain d et une source s. La grille g, le drain d, et la source s du capteur de courant image 322 sont connectés respectivement aux bornes 310, 262 et 316.

Le capteur de température 324 est configuré pour mesurer et fournir un signal d'une température T représentative de la température régnant au sein du transistor de puissance 58. Le capteur de température 324 est un transistor configuré pour fournir au travers de deux bornes 326, 328 d'accès, reliées respectivement aux bornes 312, 314, un signal représentatif de la température T.

L'unité de commande 306 du limiteur est configurée pour commander le transistor de puissance 258 en fonction de paramètres de mesure compris dans l'ensemble constitué par la température T, mesurée par le capteur de température 324, et le courant image, mesuré par le capteur de courant 322.

L'unité de commande 306 comprend une première borne de sortie 332, une deuxième borne d'entrée 334, une troisième borne de sortie 336, une quatrième borne d'entrée 338, une cinquième borne d'entrée 340, une sixième borne d'entrée 342 et une septième borne d'entrée 344, connectées respectivement aux bornes 310, 262, 308, 312, 314, 316 et 318 du composant intégré 304 du limiteur.

La première borne de sortie 332 est apte à fournir un signal de commande à la grille g du capteur du courant image 322 et la deuxième borne de sorte 334 est apte à recevoir la tension V_{C} du drain D du transistor de puissance 58 comme tension de référence du transistor 58.

La troisième borne de sortie 336 est apte à fournir à l'électrode de grille G du transistor de puissance 58 une commande de tension V_{CMD} de réglage de la valeur d'un courant de saturation en fonction de paramètres de mesure fournis par le composant intégré du limiteur 304, c'est-à-dire le courant image du transistor de puissance et/ou la température T.

La quatrième 338 et la cinquième 340 bornes d'entrée sont aptes à recevoir le signal de température T sous la forme d'une tension différentielle.

La sixième 342 et la septième 344 bornes d'entrée sont aptes à recevoir le signal de courant image sous la forme d'un courant.

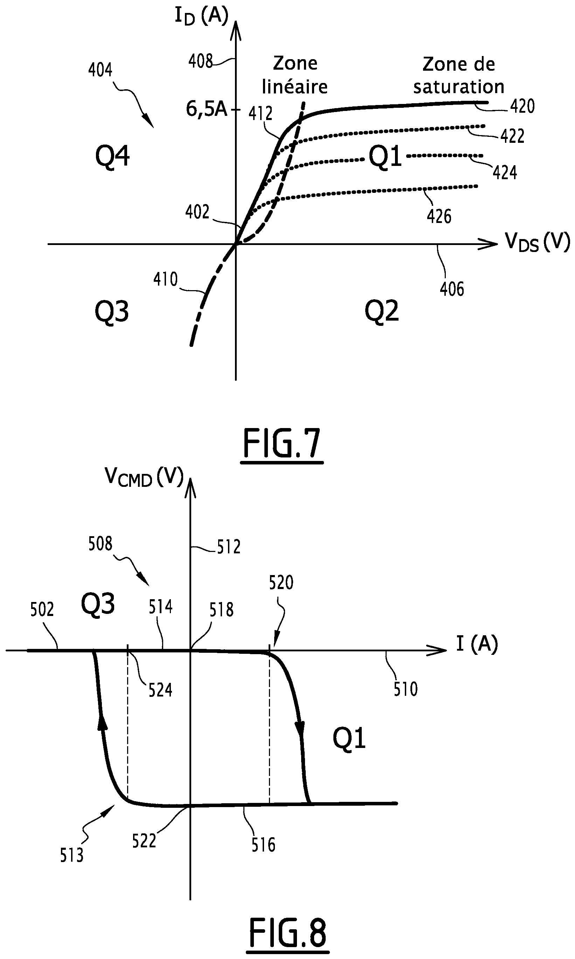

Suivant la Figure 7, un ensemble de caractéristiques d'évolution 402 du courant de drain I_{D} en fonction de la tension source(S)-drain(D) V_{DS} du transistor 258, paramétrées par la valeur de la tension V_{G} de grille G est représenté dans un repère 404.

Le repère 404 comporte en axe des abscisses un premier axe 406 de tension V_{DS}, la tension V_{DS} étant égale à la tension V_{AC}, dont l'unité est exprimée en volts et en axe des ordonnées un deuxième axe 408 de courant I_{D} dont l'unité est exprimée en ampère.

Le repère 404 comprend à l'instar du repère 104 décrit dans la Figure 2, quatre quadrants désignés respectivement par les références Q1, Q2, Q3 et Q4.

Les caractéristiques de l'ensemble 402 comprennent une première zone commune 410 en polarisation inverse qui est indépendante de la valeur de la tension de grille V_{G} et dans laquelle le transistor de puissance 258 fonctionne lorsque la première branche d'alimentation 212 fonctionne normalement.

Pour chaque valeur de la tension de grille V_{G}, la caractéristique comprend une deuxième zone, en polarisation directe, formée d'une première sous-zone linéaire et d'une deuxième sous-zone linéaire raccordée à la première sous- zone linéaire.

La pente de la première sous-zone de la deuxième zone est sensiblement la même indépendamment de la valeur de la tension de grille V_{G}.

La pente de la deuxième sous-zone de la deuxième zone est sensiblement proche de zéro et sensiblement la même indépendamment de la de la valeur de la tension de grille V_{G}.

La pente de la première sous-zone est nettement supérieure à la pente de la deuxième sous-zone dans un rapport supérieur à 10.

Une deuxième zone en trait plein correspond à une valeur de tension de grille, supposée ici égale à zéro volt, pour laquelle le canal du transistor de puissance est faiblement pincé latéralement et la valeur seuil du courant de saturation est la plus grande, ici égale à 1,3 fois la valeur du courant d'alimentation de la première branche en fonctionnement normal c'est-à-dire 6,5 A. La première sous-zone et la deuxième sous-zone de saturation correspondante à cette tension de grille sont désignées respectivement par les références numériques 412 et 420.

Trois autres deuxièmes zones sont représentées en trait pointillés avec chacune leur deuxième sous-zone, les sous-zones étant désignées par les références 422, 424, 426. A chaque deuxième sous-zone 422, 424, 426 est associée une tension de grille différente qui décroît suivant l'ordre croissant des références numériques 422, 424, 426.

Lorsque la tension de grille V_{G} décroît algébriquement, c'est-à-dire ici lorsque V_{G} est négatif et l'amplitude de V_{G} croit, le pincement d'un canal du transistor de puissance à effet de champ est plus élevé et la valeur limite de saturation du courant de drain décroît.

Suivant la Figure 8, un exemple d'une courbe 502 d'évolution de la tension de commande V_{CMD} appliquée à la grille G du transistor de puissance 258 en fonction du courant image seul est représenté dans un repère 508.

Le repère 508 comprend en abscisses un premier axe 510 de courant image, et un deuxième axe 512 de tension de commande de la tension de la grille G du transistor de puissance 258.

La courbe 502 correspond à un premier mode de réalisation de commande dans lequel la tension de commande V_{CMD} de la grille G dépend seulement du courant image c'est-à-dire du courant de puissance du transistor de puissance 258.

La courbe 502 d'évolution de la tension de commande V_{CMD} en fonction du courant image seul décrit une première boucle d'hystérésis 513, comprend un premier tronçon 514 orienté dans le sens d'un courant image croissant et un deuxième tronçon 516 orienté dans le sens d'un courant image décroissant.

Dans le premier tronçon 514, alors qu'initialement la tension de commande de grille est égale à une première valeur de tension de commande 518, ici zéro volt, tant que le courant image reste inférieur à une première valeur de seuil 520 de déclenchement, alors la valeur de la tension de commande V_{CMD} est égale à la première valeur 518 de tension de commande.

Lorsque le courant image dépasse la première valeur de seuil 520 de déclenchement en courant image en croissant, la tension de commande décroît jusqu'à une deuxième valeur de tension de commande 522 et y reste si le courant image continue à croître.

Dans le deuxième tronçon 516, alors qu'initialement la tension de commande de grille est égale à la deuxième valeur de tension de commande 522, tant que le courant image reste supérieur ou égal à une deuxième valeur de seuil 524 de déclenchement de courant image, alors la valeur de la tension de commande est égale à la deuxième valeur de tension de commande 522.

Lorsque le courant image dépasse la deuxième valeur de seuil 524 de déclenchement en courant image en décroissant, la tension de commande décroît brusquement jusqu'à la première valeur de tension de commande 518 et y reste si le courant image continue à décroître.

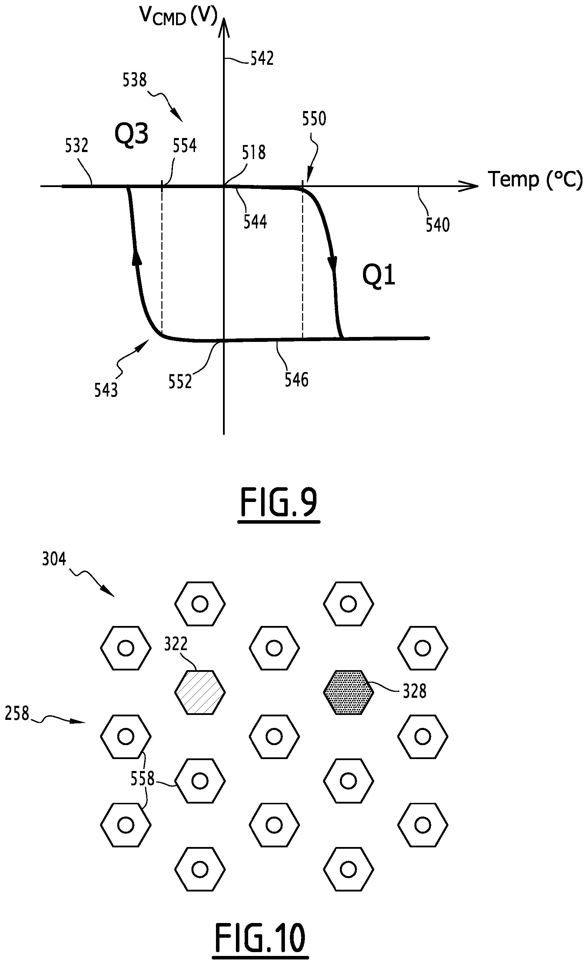

Suivant la Figure 9, un exemple d'une courbe 532 d'évolution de la tension de commande V_{CMD} appliquée à la grille G du transistor de puissance 258 en fonction de la température T seule est représentée dans un repère 538.

Le repère 538 comprend en abscisses un premier axe 540 de température, et un deuxième axe 542 de tension de commande V_{CMD} de la tension de la grille G du transistor de puissance 258.

La courbe 532 correspond à un deuxième mode de réalisation de commande dans lequel la tension de commande V_{CMD} de la grille G dépend seulement de la température régnant au sein du transistor de puissance 258.

La courbe 532 d'évolution de la tension de commande V_{CMD} en fonction de la température seule décrit une première boucle d'hystérésis 543, comprend un premier tronçon 544 orienté dans le sens d'une température croissante et un deuxième tronçon 546 orienté dans le sens d'une température décroissante.

Dans le premier tronçon 544, alors qu'initialement la tension de commande de grille G est égale à la première valeur de tension de commande 518, ici zéro volt, tant que la température T reste inférieure à une première valeur de seuil 550 de déclenchement en température, alors la valeur de la tension de commande est égale à la première valeur de tension de commande 518.

Lorsque la température dépasse la première valeur de seuil 550 de déclenchement en température en croissant, la tension de commande V_{CMD} décroît jusqu'à une troisième valeur de tension de commande 552 et y reste si la température T continue à croître.

Dans le deuxième tronçon 546, alors qu'initialement la tension de commande V_{CMD} de grille G est égale à la troisième valeur de tension de commande 552 de la grille G, tant que la température T reste supérieure ou égal à une deuxième valeur de seuil 554 de déclenchement en température, alors la valeur de la tension de commande V_{CMD} est égale à la troisième valeur de tension de commande 55.

Lorsque la température T dépasse la deuxième valeur de seuil 554 de déclenchement en température en décroissant, la tension de commande V_{CMD} décroît brusquement jusqu'à la première valeur de tension de commande 518 et y reste si la température continue à décroître.

Dans la pratique, un troisième mode de réalisation de la fonction de commande combine les premier et deuxième modes de réalisation, et dans ce mode, la tension de commande V_{CMD} de la grille G dépend à la fois du courant image et de la température.

Il est à remarquer que la température est avant tout un paramètre de sécurité du limiteur lui-même tandis que le courant image est un paramètre de sécurité de la source de tension de la première branche et plus généralement du système d'alimentation.

Dans le troisième mode de réalisation, la tension de commande la plus conservative, c'est à dire celle qui correspond à une valeur de seuil la plus grande, est appliquée par rapport à un état de franchissement des seuils du couple de paramètres formé par le courant image et la température.

Par exemple, si à la deuxième valeur de tension de commande correspond un courant de saturation plus faible que le courant de saturation correspondant à la troisième valeur de tension de commande, et si la première valeur de seuil de déclenchement en courant image est franchie en croissant tandis que la première valeur de seuil de déclenchement en température n'est pas franchie, alors la deuxième valeur de tension est appliquée.

Si la première valeur de seuil de déclenchement de la température est franchie en croissant tandis que la première valeur de seuil de déclenchement en courant image n'est pas franchie, alors la troisième valeur de tension est appliquée

Si la première valeur de seuil de déclenchement en courant image et la première valeur de seuil de déclenchement en température sont franchies en croissant, alors la troisième valeur de tension est appliquée.

Si la tension de commande appliquée initialement est égale à la troisième valeur de tension de commande, si la deuxième valeur de seuil déclenchement de la température en décroissant est franchie tandis que la deuxième valeur de seuil de courant image n'est pas franchie en décroissant, alors la deuxième valeur de tension de commande est appliquée.

Si la tension de commande appliquée initialement est égale à la troisième valeur de tension de commande, si la deuxième valeur de seuil de déclenchement en courant image est franchie en décroissant tandis que la deuxième valeur de seuil déclenchement de la température en décroissant n'est pas franchie en décroissant, alors la tension de commande reste à la troisième valeur de tension de commande.

Si la tension de commande appliquée initialement est égale à la troisième valeur de tension de commande, si la deuxième valeur de seuil déclenchement de la température et la deuxième valeur de seuil de courant image ne sont pas franchies en décroissant, alors la première valeur de tension de commande est appliquée.

Suivant la Figure 10, un exemple d'implantation des transistors du composant électronique intégré 304 de limiteur est proposé dans lequel le transistor JFET de puissance 258 est un transistor VJFET, réparti en plusieurs transistors de puissance élémentaires 558 dont les électrodes élémentaires de même type sont reliées entre elles.

Les électrodes de type drain, respectivement de type source et de type grille, sont reliées entre elles, pour former l'électrode de drain D, respectivement l'électrode de source S et le ou les électrodes de grille du transistor de puissance 258.

Les couches planes des divers matériaux, notamment les matériaux semiconducteurs, formant chaque transistor élémentaire ont globalement une forme hexagonale.

Les transistors de puissance élémentaires 558 sont répartis selon un maillage de cellules de forme hexagonale, chaque transistor de puissance élémentaire 558 constituant un noeud de ce maillage.

Suivant la Figure 10, le capteur de courant image 322 est un transistor de type VJFET de structure analogue aux transistors de puissance élémentaires 558 en termes de répartition verticale des divers types de couche. Le capteur de courant 322 est un noeud dans le maillage formé par les transistors de puissance élémentaires 558.

Le capteur de température 328 est basé sur un transistor de type VJFET, de structure analogue aux transistors de puissance élémentaires 558 en termes de répartition verticale des divers type de couches formant le composant limiteur 304. Le capteur de température 328 est également un noeud dans le maillage formé par les transistors de puissance élémentaires 558.

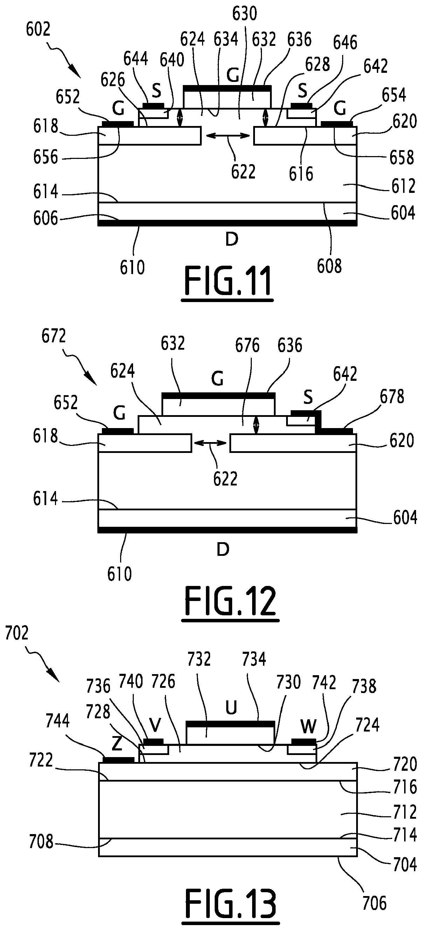

Suivant la Figure 11 et une première forme de réalisation 602 d'un transistor élémentaire de puissance élémentaire 558, le transistor de puissance élémentaire 602 comprend :
un substrat 604 d'un premier type de conductivité, par exemple une couche d'épitaxie de type n, présentant une première face inférieure 606 et une première face supérieure 608 ;
une électrode de drain 610 en contact avec la première face inférieure 606 du substrat 604 ;
une première région semi-conductrice 612 du premier type de conductivité, présentant une deuxième face inférieure 614 agencée sur la première face supérieure 608 du substrat 604, et une deuxième face supérieure 616 ;
une deuxième 618 et une troisième région 620 semi-conductrices d'un second type de conductivité, par exemple de type p, partiellement enterrées, agencées à l'intérieur de la première région semi-conductrice 612 sous la deuxième face supérieure 616 et délimitant à l'intérieur de la première région 612 un canal vertical 622 ;
une quatrième région semi-conductrice 624, du premier type de conductivité comme pour la première région, recouvrant centralement, partiellement et respectivement une troisième face 626 et une quatrième face 628 supérieures des deuxième 618 et troisième 620 régions, la quatrième région 624 formant un canal latéral 630,
une cinquième région semi-conductrice 632 du deuxième type de conductivité, dite de surface, recouvrant centralement et partiellement une cinquième face supérieure 634 de la quatrième région semi-conductrice 624,
une première électrode de grille de commande 636 disposée sur la cinquième région semi-conductrice 632;
une première zone de contact 640 et une deuxième zone de contact 642 symétriques entre elles, disposées sous la cinquième face supérieure 634 dans deux zones non recouvertes par la cinquième région 632 ;
une première électrode de source 644 et une deuxième électrode de source 646 disposées respectivement sur la première zone de contact 640 et la deuxième zone de contact 642; et
une deuxième électrode de grille 652 et une troisième électrode de grille 654 disposées respectivement sur une sixième face supérieure 656 de la deuxième région semi-conductrice 618 et une septième face supérieure 658 de la troisième région semi-conductrice 620 dans des zones non recouvertes par la quatrième région semi-conductrice 624.

Suivant la figure 12, une deuxième forme de réalisation 672 d'un transistor de puissance 658 est représentée dans laquelle les éléments identiques à ceux de la première forme de réalisation 602 du transistor de puissance élémentaire décrit à la Figure 10 sont désignés par des références numériques identiques.

Les éléments communs sont les éléments désignés par les références numériques 604, 610, 614, 618, 620, 622, 624, 632, 636, 642, 652.

Le transistor de puissance élémentaire 672 comporte une seule grille 652 de commande d'une région d'appauvrissement enterrée, ici la deuxième région 618, la deuxième grille de commande d'une région d'appauvrissement ayant été ici supprimée.

De même, la première électrode de source 644 et sa zone de contact 640 associée ont été supprimées.

La deuxième électrode de source 646 a été remplacée par une électrode de source unique 678 dont une portion recouvre la zone de contact 642, vient déborder la face de dessus de la quatrième région 624 à droite sur la figure 12 et est prolongée par une deuxième portion qui recouvre la troisième région 620.

Ainsi la largeur de pincement du canal vertical 622 situé entre les parois verticales de la deuxième région 618 et la troisième région 620 est fonction de la tension appliquée à l'électrode de grille 652 et de la tension appliquée à l'électrode de source unique 678.

Le canal latéral 678 est ici à l'inverse du canal latéral de la Figure 11 un canal asymétrique situé à droite sur la Figure 12 et délimité par la face supérieure de la troisième région 620 et la face supérieure de la quatrième région 624.

Suivant la Figure 13, un capteur de température 328 est un composant électronique 702 multicouche de type analogue aux transistors de puissance élémentaires 602, 672.

Le capteur électronique de température 702 comprend :
un substrat 704 d'un premier type de conductivité, par exemple une couche d'épitaxie de type n, présentant une première face inférieure 706 et une première face supérieure 708 formant une première couche ;
une première région semi-conductrice 712 du premier type de conductivité, formant une deuxième couche présentant une deuxième face inférieure 714 agencée sur la première face supérieure 708 du substrat 704, et une deuxième face supérieure 716 ;
une deuxième région semi-conductrice 720 d'un second type de conductivité, par exemple de type p, formant une troisième couche présentant une troisième face inférieure 722 recouvrant en totalité la deuxième face supérieure 716 et une troisième face supérieure 724,
une troisième région semi-conductrice 726 du premier type de conductivité, formant une quatrième couche présentant une quatrième face inférieure 728 recouvrant centralement, partiellement et respectivement la troisième face supérieure 724, et une quatrième face supérieure 730 ;
une quatrième région semi-conductrice 732 du deuxième type de conductivité, formant une cinquième couche recouvrant centralement et partiellement la quatrième face supérieure 730 de la troisième région semi-conductrice 726 ;
une première électrode 734 disposée sur la quatrième région semi-conductrice 732 et désignée par la lettre U;
une première zone de contact 736 et une deuxième zone de contact 738 symétriques entre elles, disposées sous la quatrième face supérieure 730 dans une zone non recouverte par la quatrième région 732 ;
une deuxième électrode 740 et une troisième électrode 742, disposées respectivement sur la première zone de contact 736 et la deuxième zone de contact 738, et désignées respectivement par les lettres V et W ; et
une quatrième électrode 744 disposée sur la face supérieure de la deuxième région semi-conductrice désignée par la lettre Z.

Différents types de combinaisons des électrodes U, V, W, Z peuvent être exploitées pour réaliser le capteur de température, le deuxième région semi-conductrice 720 servent de couche isolante.

La jonction V-U ou la jonction W-U constitue un capteur de température de type jonction P-N.

La jonction V-W constitue un capteur de température de type résistif.

La double jonction V-U-W constitue un capteur de température de type JFET latéral.

Il est à remarquer que les différentes fonctions réalisées par les transistors décrits précédemment dans les Figures 11, 12 et 13 peuvent être également réalisées en variante par des transistors dans lesquels les types de zones N et P décrits dans les Figures 11, 12 et 13 sont inversés.

Il est à remarquer également que les fonctions décrites précédemment et intégrées sur un même substrat semi-conducteur suivant la Figure 10, peuvent également être réalisées en variante sure des puces différentes assemblées dans un même boitier ou module.

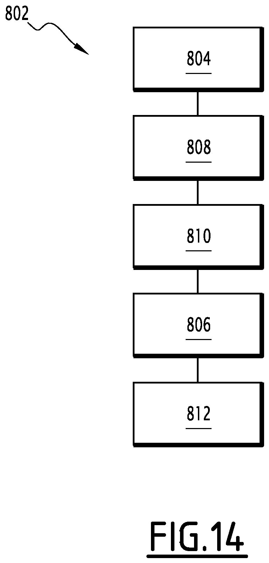

Suivant la Figure 14, un procédé 802 de mise en oeuvre de la protection d'un système d'alimentation tel que décrit à la Figure 1 ou à la Figure 5 comprend la succession d'une ou plusieurs étapes.

Dans une première étape 804, lorsque la première branche d'alimentation fonctionne normalement, le transistor FET de puissance de limitation en courant fonctionne dans la première zone, c'est-à-dire sans limitation du courant et en polarisation inverse, la grille G étant mise à un potentiel correspondant au pincement le plus faible du canal du transistor de puissance, c'est-à-dire la largeur de canal la plus grande atteignable.

Dans une deuxième étape 806, lorsqu'un défaut de mise en court circuit interne d'une partie ou de la totalité de la source de tension de la première branche d'alimentation 12 a lieu, le transistor FET de puissance fonctionne dans la deuxième zone, en mode de conduction directe avec une limitation en courant à partir d'une valeur de seuil de courant prédéterminée.

Dans une variante, les deux étapes 804, 806 peuvent être mise en oeuvres seules et le procédé ne comprend pas d'étapes dans lesquelles un organe de commande fait varier la tension de la grille G pour contrôler la valeur du seuil de limitation en courant en fonction notamment du courant image et de la température T.

Le procédé 802 comprend une troisième étape 808, postérieure à la première étape 804 et antérieure à la deuxième étape 806. En variante, la troisième étape 808, est omise.

Dans la troisième étape 808, lorsque la première branche d'alimentation fonctionne normalement en terme de non occurrence d'un défaut de court circuit interne de la première source de tension, lorsque le courant traversant le transistor de puissance dépasse la valeur de courant nominal et la température du limiteur reste inférieure à une première valeur de seuil de température du transistor, le transistor de puissance continue de fonctionner dans la première zone.

Dans la même troisième étape 808, lorsque la première branche d'alimentation fonctionne normalement en termes de non occurrence d'un défaut de court circuit interne de la première source de tension, lorsque le courant traversant le transistor de puissance dépasse la valeur de courant nominal et la température du limiteur dépasse en croissant la première valeur de seuil de température du transistor, un organe de coupure comme par exemple un disjoncteur ou un fusible coupe le transistor. Ainsi, la troisième étape 808 protège le système d'alimentation en cas d'une surcharge ou d'un court circuit sur la charge.

Dans une quatrième étape 810, antérieure à l'étape 806 et postérieure à l'étape 804, le capteur de courant image mesure un courant représentatif du courant de puissance traversant le transistor de puissance. Lorsqu'un défaut a lieu sur la première branche en termes de court circuit interne de la première source de tension, le courant de puissance et le courant image inversent leur sens et lorsque le courant image dépasse une première valeur de seuil de déclenchement, l'organe de commande envoie une commande de mise de la tension de la grille G du transistor de puissance à une deuxième valeur de tension de grille de façon à régler une deuxième valeur de saturation du courant de puissance.

Dans la même quatrième étape 810, lorsque la branche d'alimentation fonctionne normalement, la tension de commande de la grille reste à la première valeur de commande et le transistor fonctionne dans la première zone.

Dans une second mode de réalisation de l'étape 810, le capteur de température mesure une température représentative de la température de la jonction du transistor de puissance. Lorsqu'un défaut a lieu sur la première branche en termes de court circuit interne de la première source de tension, le courant de puissance et le courant image inversent leur sens et lorsque la température dépasse une première valeur de seuil de déclenchement en température, l'unité de commande envoie une commande de mise de la tension de la grille G du transistor de puissance à une troisième deuxième valeur de tension de grille de façon à régler une troisième valeur de saturation du courant de puissance.

Dans un troisième mode de réalisation de la quatrième étape 810, le capteur de température mesure la température et le capteur de courant mesure le courant image. Lorsqu'un défaut a lieu sur la première branche en termes de court circuit interne de la première source de tension, le courant de puissance et le courant image inversent leur sens et lorsque la température dépasse en croissant une première valeur de seuil de déclenchement en température et/ou lorsque le courant image dépasse en croissant une première valeur de seuil de déclenchement en courant image, l'organe de commande envoie une commande de mise de la tension de la grille G du transistor de puissance à une valeur de tension de commande conservative par rapport à l'état de dépassement du couple formé par le premier seuil de déclenchement en courant image et le premier seuil de déclenchement en température.

La valeur de tension conservative est la valeur de tension parmi la deuxième et la troisième valeur de tension de commande qui correspond à une valeur de courant de saturation le plus petit lorsque le premier seul de déclenchement en courant image et le premier seul de déclenchement en température sont dépassés.

Lorsque seul le premier seuil de déclenchement en courant image est dépassé, la tension de commande est égale à la deuxième valeur de tension de commande.

Lorsque seul le premier seuil de déclenchement en température est dépassé, la tension de commande est égale à la troisième valeur de tension de commande.

En pratique dans la troisième variante de la quatrième étape 810, la valeur du courant de saturation correspondant à troisième valeur de tension de commande est plus petit que la valeur du courant de saturation correspondant à troisième valeur de tension de commande.

Dans un premier mode de réalisation d'une cinquième étape 812 postérieure à la deuxième étape 806, le transistor de puissance fonctionne dans la deuxième zone de limitation. Lorsque le défaut de court circuit interne de la première source de tension cesse et que la première branche d'alimentation fonctionne à nouveau normalement, lorsque la tension de commande est égale à la deuxième valeur de tension de commande, lorsque le capteur de courant image mesure le courant image, et lorsque le courant image dépasse en décroissant une deuxième valeur de seuil de déclenchement en courant image, l'organe de commande met la tension de commande la grille G à la valeur de la première tension de commande.

Dans un deuxième mode de réalisation de la cinquième étape 812, lorsque le défaut de court circuit interne de la première source de tension cesse et que la première branche d'alimentation fonctionne à nouveau normalement, lorsque la tension de commande est égale à la troisième valeur de tension de commande, lorsque le capteur de température mesure la température, et lorsque la température dépasse en décroissant une deuxième valeur de seuil de déclenchement en température, l'organe de commande met la tension de la grille G à la valeur de la première tension de commande.

Dans un troisième mode de réalisation de la cinquième étape 812, lorsque le défaut de court circuit interne de la première source de tension cesse et que la première branche d'alimentation fonctionne à nouveau normalement, lorsque la tension de commande est égale à la deuxième valeur ou la troisième valeur de tension de commande, lorsque le capteur de température mesure la température et le capteur de courant image mesure le courant image, lorsque la température dépasse en décroissant la deuxième valeur de seuil de déclenchement en température et/ou lorsque le courant image dépasse en décroissant la deuxième première valeur de seuil de déclenchement en courant image, l'unité de commande envoie une commande de mise de la tension de la grille G du transistor de puissance à une valeur de tension conservative par rapport à l'état de dépassement du couple formé par le deuxième seuil de déclenchement en courant image et le premier seuil de déclenchement en température.

La valeur de tension conservative est la première valeur de tension lorsque le deuxième seuil de déclenchement en courant image et lorsque le deuxième seuil de déclenchement en température sont dépassés.

Lorsque seul le deuxième seuil de déclenchement en courant image est dépassé, la tension de commande est égale à la troisième valeur de tension.

Lorsque seul le deuxième seuil de déclenchement en température est dépassé en décroissant, la tension de commande est égale à la deuxième valeur de tension.

En pratique dans la troisième variante de la cinquième étape 810, la valeur du courant de saturation correspondant à la troisième valeur de tension de commande est plus petit que la valeur du courant de saturation correspondant à troisième valeur de tension de commande.

En pratique, lorsque aucun courant ne circule dans le transistor de puissance, le composant intégré et la tension de grille g du capteur de courant image sont configurés pour laisser passer un courant résiduel et détecter une inversion de courant lorsque la première source de tension fonctionne à nouveau normalement.

Lorsqu'une inversion du courant est détectée par le capteur de courant, la tension d'inhibition complète du transistor de puissance est supprimée.

Ainsi, la surveillance du signe du courant résiduel traversant le capteur de courant permet la détection de la suppression d'un défaut ou de la disparition de ce défaut et assure ainsi un retour du système à un fonctionnement normal. En cas de défaut le courant passe d'une valeur négative à une valeur positive, le système de commande coupe la conduction du transistor principal tout en surveillant le signe du courant. Si le courant redevient négatif, la tension de commande de blocage du transistor de puissance est supprimée.

En variante, la suppression de la tension de d'inhibition complète du transistor de puissance est maintenue tant que le transistor de puissance fonctionne dans la première zone.

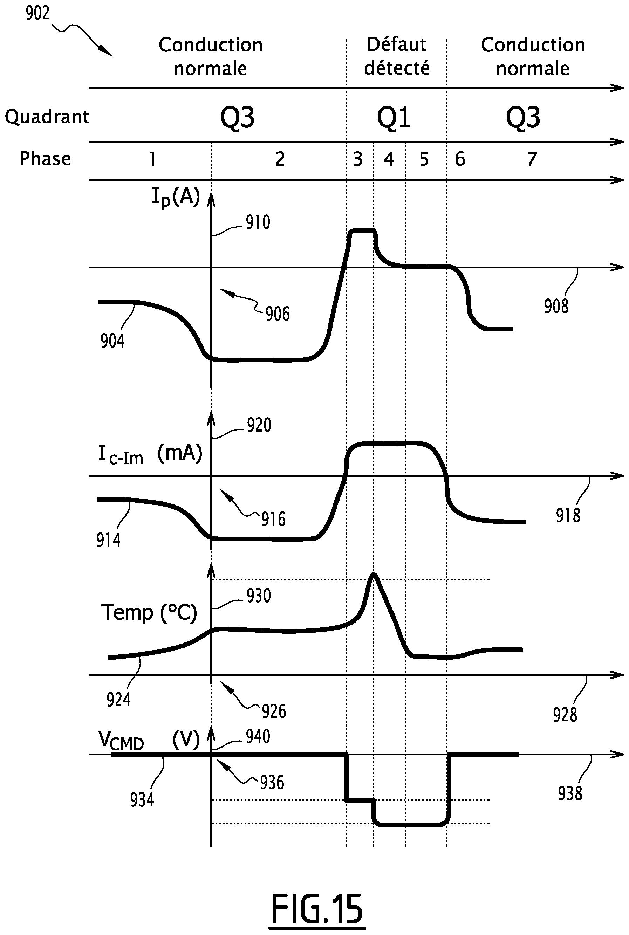

Suivant la Figure 15, une vue de l'évolution des grandeurs caractéristiques du limiteur est fournie pour une séquence de fonctionnement particulière du système d'alimentation décrit à la Figure 1 ou la Figure 5.

Les grandeurs caractéristiques comprennent le courant de puissance, traversant le transistor de puissance du limiteur, le courant image capté par le capteur de courant image, la température captée par le capteur de température, et la tension de commande appliquée à la grille G du transistor de puissance.

Une courbe d'évolution temporelle 904 du courant de puissance, noté Ip dans la Figure 15, est représentée dans un repère 906, comportant un axe des temps 908 en abscisses et un axe de courant 910 dont l'unité est exprimée en ampère.

Une courbe d'évolution temporelle 914 du courant image, noté Ic-Im dans la Figure 15, est représentée dans un repère 918, comportant un axe des temps 918 en abscisses et un axe de courant 920 dont l'unité est exprimée en milliampère.

Une courbe d'évolution temporelle 924 de la température, noté Temp dans la Figure 15, est représentée dans un repère 926, comportant un axe des temps 928 en abscisses et un axe de température 930 dont l'unité est exprimée en degré Celsius.

Une courbe d'évolution temporelle 934 de la tension de commande V_{CMD}, est représentée dans un repère 936, comportant un axe des temps 938 en abscisses et un axe de tension 940 dont l'unité est exprimée en volts.

La séquence comprend une succession de phases numérotées de 1 à 7.

Dans la phase 1 le système d'alimentation fonctionne normalement. Le transistor de puissance du limiteur est traversé par un courant de valeur nominal et fonctionne dans la première zone de sa caractéristique, c'est-à-dire dans le troisième quadrant Q3.

Dans la phase 2, le système d'alimentation fonctionne normalement mais avec une légère surcharge qui se traduit par un courant traversant le transistor de puissance de valeur légèrement supérieure pouvant aller jusqu'à 1,3 fois la valeur du courant nominal.

Il est à remarquer que lorsque cette surcharge est trop importante, ce qui se traduit par une élévation de température pouvant endommager irrémédiablement le limiteur, il est prévoir un dispositif supplémentaire de coupure de ce courant de surcharge.

Au début de la phase 3, un défaut a lieu sur le système d'alimentation qui se traduit par la mise en court circuit interne d'un ou plusieurs modules de la première branche dans lequel le limiteur est branché en série et une inversion du sens du courant de puissance.

La capteur de courant image détecte une inversion du courant image et génère une tension de commande de tension négative appliquée à la grille G du transistor de puissance 258. La valeur de cette tension de commande dépend également de la température mesure par le capteur de température. Ici, le premier seuil de déclenchement en température n'a pas été franchi et la valeur de la tension de commande est égale à la deuxième valeur de commande.

Pendant la phase 3, la valeur de la tension de commande de la grille G est maintenue à la deuxième valeur de la tension de commande. Toutefois, la valeur du courant de saturation correspondant à cette commande ne limite pas suffisamment et la température du transistor de puissance continue à croître dangereusement.

En début de phase 4, la capteur de température détecte le dépassement d'une température critique fixé par le premier seuil de déclenchement en température et l'unité de commande génère une tension de commande appliquée à la grille G égale à une troisième valeur de tension de commande. Ici, la valeur de la troisième tension de commande est plus élevée que la valeur de la deuxième tension de commande et correspond au blocage du transistor de puissance c'est-à-dire à l'annulation du courant de puissance. Le courant image continue toutefois à être surveillé par le capteur de courant image. La température décroît tandis que la tension de commande est maintenue à la troisième valeur de tension de commande.

Dans la phase 5, tension de commande étant maintenue à la troisième valeur de tension de commande, aucun courant de puissance ne circule dans le transistor de puissance, seul un courant plancher résiduel circulant dans le transistor formant le capteur de courant image.

La température qui a dépassé un deuxième seuil de déclenchement en température se maintient à une valeur stable de sécurité.

Dans la fin de la phase 5, le court circuit interne de la première branche disparaît et le système d'alimentation se met nouveau à fonctionner normalement. Cela se traduit par une inversion du courant image et la génération d'une tension de commande appliquée à la grille G égale à la première valeur de tension de commande, c'est-à-dire zéro volt.

Le transistor de puissance 258 fonctionne à nouveau dans la première zone de sa caractéristique c'est-à-dire dans le troisième quadrant Q3.

Dans la phase 6, l'amplitude du courant de puissance négatif croit jusqu'à atteindre la valeur du courant nominal qui traverse la première branche en fonctionnement normal.

Dans la phase 7, les valeurs des paramètres caractéristiques sont permanentes et identiques à celles de la phase 1. Le système d'alimentation fonctionne normalement et le limiteur est opérationnel pour protéger le système en cas d'u nouveau court circuit interne sur la première branche d'alimentation.

## Revendications

1. Système d'alimentation électrique, apte à alimenter une charge électrique (4 ; 204) en un courant d'alimentation prédéterminé sous une tension d'alimentation prédéterminée, comprenant une première branche d'alimentation électrique (12 ; 212) et une deuxième branche d'alimentation électrique (14 ; 214) connectées en parallèle,
la première branche d'alimentation (12 ; 212) comportant, connectés en série, une première source de tension (244) et un limiteur en courant (56 ; 256), et la deuxième branche d'alimentation (14 ; 214) comportant une deuxième source de tension (246),
la première source de tension (244) et la deuxième source de tension (246) ayant chacune, lorsqu'elles fonctionnent normalement, une même force électromotrice dont le sens de polarisation et l'amplitude sont identiques au sens de polarisation et l'amplitude de la tension d'alimentation,
le limiteur en courant (56 ; 256) comportant un transistor de puissance à effet de champ (58 ; 258) avec une première borne de connexion électrique (62 ; 262) et une deuxième borne de connexion électrique (64 ; 264) et dont un canal de puissance délimité entre la première borne (62 ; 262) et la deuxième borne (64 ; 264) forme un dipôle électrique branché en série à la première source de tension (244) en la deuxième borne de connexion (64 ; 264),
le transistor de puissance (58 ; 258) ayant une caractéristique d'évolution d'un courant électrique traversant le canal de puissance en fonction d'une tension électrique différentielle entre les première et deuxième bornes de connexion (62, 64 ; 262, 264), la tension électrique différentielle étant égale à une tension électrique de la première borne (62, 262) moins une tension électrique de la deuxième borne (64 ; 264) et le courant électrique traversant le canal de puissance ayant un sens positif lorsqu'il circule de la première borne de connexion (62 ; 262) vers la deuxième borne de connexion (64, 264),
la caractéristique d'évolution du transistor de puissance (58, 258) comprenant une première zone (118), en polarisation inverse, dans laquelle la tension électrique et le courant ont un même sens négatif et le courant traversant le canal est dépourvu de limitation, et une deuxième zone (120) de limitation unidirectionnelle en courant, en conduction directe, dans laquelle la tension électrique différentielle et le courant électrique ont le même sens et sont positifs et le courant électrique traversant le canal de puissance est limité en courant à partir d'un seuil de courant, dans lequel :
le transistor de puissance à effet de champ (58 ; 258) est un transistor à effet de champ compris dans la famille des transistors JFET et MOS, et dont le substrat semi-conducteur est fabriqué dans un matériau à large bande interdite, notamment du silicium, du carbure de silicium, du nitrure de gallium GaN et du diamant, de préférence dans du silicium ou du carbure de silicium,
le transistor de puissance à effet de champ (58 ; 258) est connecté à la première source de tension (244) sous une polarisation inverse, dans une configuration où la tension différentielle du transistor de puissance (58 ; 258) et la force électromotrice de la première source de tension (244), lorsque la première branche d'alimentation fonctionne normalement, sont opposées, et
lorsqu'un défaut a lieu sur la première source de tension (244) la force électromotrice de la première source de tension (244) est inférieure à la force électromotrice de la seconde source de tension (246), le transistor de puissance à effet de champ (58 ; 258) fonctionne dans la deuxième zone de limitation unidirectionnelle en courant et la première branche d'alimentation (12 ; 212) fonctionne en récepteur vis-à-vis de la deuxième branche d'alimentation (14 ; 214).

2. Système d'alimentation électrique selon la revendication 1 dans lequel la différence de tension entre la force électromotrice de la deuxième source de tension (246) et la force électromotrice de la première source de tension (244) défectueuse est supérieure ou égale à 20 volts.

3. Système d'alimentation électrique selon l'une quelconque des revendications 1 ou 2, dans lequel le rapport de la force électromotrice de la première source de tension (244) défectueuse sur la force électromotrice de la deuxième source de tension (246) est inférieur ou égal à 90%.

4. Système d'alimentation électrique selon l'une quelconque des revendications 1 à 3, dans lequel le transistor de puissance (58 ; 258) est un transistor de type VJFET dont le substrat est en carbure de silice.

5. Système d'alimentation électrique selon l'une quelconque des revendications 1 à 4, dans lequel le limiteur en courant (56) comprend :
le transistor de puissance à effet de champ (58) ayant une électrode de drain (D), une électrode de source (S), et une électrode de grille (G) de contrôle d'un courant de saturation,
un capteur de courant image (322) apte à fournir un courant image représentatif du courant de puissance traversant le canal de puissance du transistor de puissance (58),
un capteur (324) d'une température représentative d'une température régnant au sein du transistor de puissance (58),
une unité de commande (306) du limiteur en courant apte à commander le transistor de puissance (58) en fonction de paramètres de mesures compris dans l'ensemble constitué par la température mesurée par le capteur de température (324) et le courant image mesuré par le capteur de courant (322).

6. Système d'alimentation électrique selon l'une quelconque des revendications 1 à 5, dans lequel le transistor de puissance (58) comprend un ou plusieurs transistors de puissance élémentaires (558 ; 602 ; 672), chaque transistor élémentaire de puissance (558 ; 602 ; 672) comprenant :
un substrat (604) d'un premier type de conductivité présentant une première face inférieure (606) et une première face supérieure (608),
une électrode de drain (610) en contact avec la première face inférieure (606) du substrat (604),
une première région semi-conductrice (612) du premier type de conductivité présentant une deuxième face inférieure (614) agencée sur la première face supérieure du substrat (604), et une deuxième face supérieure (616),
une deuxième et une troisième région semi-conductrices (618, 620) d'un second type de conductivité, partiellement enterrées, agencées à l'intérieur de la première région semi-conductrice (612) sous la deuxième face supérieure (616) et délimitant à l'intérieur de la première région (612) un canal vertical (622),
une quatrième région semi-conductrice (624) du premier type de conductivité, de grille de surface, recouvrant centralement, partiellement et respectivement une troisième face (626) et une quatrième face (628) supérieures des deuxième et troisième régions (618, 620), la quatrième région (624) formant un canal latéral (630),
une cinquième région semi-conductrice (632) du deuxième type de conductivité recouvrant centralement et partiellement une cinquième face supérieure (634) de la quatrième région semi-conductrice (624),
une première électrode de grille de commande (636) disposée en surface de la cinquième région (624),
au moins une zone de contact (640, 642) disposée sous la cinquième face supérieure (634) dans une zone non recouverte par la cinquième région (624), et
au moins une électrode de source (646, 644) disposée sur l'au moins une zone de contact (640, 642), et
une deuxième électrode de grille (652, 654) disposée soit sur une sixième face supérieure (656), soit sur une septième face supérieure (658) dans une zone non recouverte par la quatrième région semi-conductrice (624).

7. Système d'alimentation selon la revendication 6, **caractérisé en ce que** le transistor de puissance (602) comprend
une deuxième électrode (652) et une troisième électrode de grille (654) disposées respectivement sur la sixième face supérieure (656) et la septième face supérieure (658) dans des zones non recouvertes par la quatrième région semi-conductrice (624),
les deux zones de contacts (640, 642), disposées de part et d'autre du canal vertical (622), sous la cinquième face supérieure (634) dans des zones non recouvertes par la cinquième région (632),
deux électrodes de sources (644, 646) disposées chacune sur une zone de contact différente (640, 642).

8. Système d'alimentation électrique selon la revendication 7, **caractérisé en ce que** la deuxième électrode de grille (652) est disposée sur la deuxième région semi-conductrice (618), le transistor de puissance (672) comprend une seule électrode de source (678) et une unique zone de contact (642) de l'électrode de source, et l'électrode de source (678) d'un seule tenant recouvre à la fois la zone de contact (642) et une zone de la troisième région semi-conductrice (620) non recouverte par la quatrième région semi-conductrice (624).

9. Procédé de protection d'un système d'alimentation électrique (2 ; 202) à l'aide d'un limiteur en courant (56 ; 256), le système d'alimentation électrique (2 ; 202) étant conforme à la revendication 1, ledit procédé comprend :
une première étape (804) dans laquelle, lorsque la première branche d'alimentation (12 ; 212) fonctionne normalement, le transistor de puissance (58 ; 258) fonctionne dans la première zone (118), en polarisation inverse sans limitation de courant,
une deuxième étape (806) dans laquelle, lorsqu'un défaut à lieu sur la première source de tension (244) de la première branche d'alimentation (12 ; 212), le transistor de puissance (58 ; 258) fonctionne dans la deuxième zone (120), en mode de conduction directe avec une limitation en courant à partir d'une valeur de seuil de courant.

10. Procédé de protection d'un système d'alimentation électrique selon la revendication 9, le système d'alimentation électrique (2 ; 202) étant conforme à la revendication 6, dans lequel
dans la première étape (804) la grille (G) du transistor de puissance (58) est mise à une première valeur de tension de commande de référence, et
dans lequel le procédé comprend une étape (810), antérieure à la deuxième étape (806) et postérieure à la première étape (804), dans laquelle
le capteur de courant image (322) mesure un courant représentatif du courant de puissance traversant le transistor de puissance (58),
lorsqu'un défaut a lieu sur la première branche d'alimentation (12), le courant de puissance et le courant image inversent leur sens et lorsque le courant image dépasse une première valeur de seuil de déclenchement, l'unité de commande (306) envoie une commande de mise de la tension de la grille (G) du transistor de puissance (58) à une deuxième valeur de tension de grille de façon à régler une deuxième valeur de saturation du courant de puissance,
lorsque la première branche d'alimentation (12) fonctionne normalement, la tension de commande de la grille (G) reste à la première valeur de commande et le transistor de puissance (58) fonctionne dans la première zone (118).

11. Procédé de protection d'un système d'alimentation électrique selon la revendication 10, dans lequel
dans l'étape (810), le capteur de température (324) mesure la température et le capteur de courant (322) mesure le courant image,
lorsqu'un défaut a lieu sur la première source de tension (844) de la première branche d'alimentation (12 ; 212), le courant de puissance et le courant image inversent leur sens et lorsque la température dépasse en croissant une première valeur de seuil de déclenchement en température et/ou lorsque le courant image dépasse en croissant une première valeur de seuil de déclenchement en courant image, l'unité de commande (306) envoie une commande de mise de la tension de la grille (G) du transistor de puissance (58) à une valeur de tension de commande conservative par rapport à l'état de dépassement du couple formé par le premier seuil de déclenchement en courant image et le premier seuil de déclenchement en température,
la valeur de tension de commande conservative étant la valeur de tension parmi la deuxième et la troisième valeur de tension de commande qui correspond à une valeur de courant de saturation le plus petit lorsque le premier seul de déclenchement en courant image et lorsque le premier seul de déclenchement en température sont dépassés, .
la valeur de la tension de commande conservative étant égale à la deuxième valeur de tension de commande lorsque seul le premier seuil de déclenchement en courant image est dépassé,
la valeur de la tension de commande conservative étant égale à la troisième valeur de tension de commande lorsque seul le premier seuil de déclenchement en température est dépassé.

12. Procédé de protection d'un système d'alimentation électrique selon la revendication 11, dans lequel
lorsqu'aucun courant ne circule dans le transistor de puissance (58) et que le capteur de courant (322) en fournit une valeur image correspondant à un biais, le capteur de température (324) poursuit la surveillance du courant image, et
lorsqu'une inversion du courant est détectée par le capteur de courant représentative d'un basculement d'un fonctionnement du limiteur (56) depuis la première zone (118) dans la deuxième zone (120), la tension de commande d'inhibition complète de circulation du courant de puissance dans le transistor de puissance (58) est supprimée.

## Patentansprüche

1. Elektrisches Versorgungssystem, das geeignet ist, eine elektrische Last (4; 204) mit einem vorbestimmten Versorgungsstrom bei einer vorbestimmten Versorgungsspannung zu versorgen, einen ersten elektrischen Versorgungszweig (12; 212) und einen zweiten elektrischen Versorgungszweig (14; 214), die parallel geschaltet sind, umfassend, wobei
der erste Versorgungszweig (12; 212) eine erste Spannungsquelle (244) und einen Strombegrenzer (56; 256) aufweist, die in Reihe geschaltet sind, und der zweite Versorgungszweig (14; 214) eine zweite Spannungsquelle (246) aufweist,
die erste Spannungsquelle (244) und die zweite Spannungsquelle (246) bei normalem Betrieb jeweils eine gleiche elektromotorische Kraft aufweisen, deren Polarisierungsrichtung und Amplitude identisch zu der Polarisierungsrichtung und der Amplitude der Versorgungsspannung sind,
der Strombegrenzer (56; 256) einen Leistungsfeldeffekttransistor (58; 258) mit einem ersten elektrischen Verbindungsanschluss (62; 262) und einem zweiten elektrischen Verbindungsanschluss (64; 264) aufweist und dessen zwischen dem ersten Anschluss (62; 262) und dem zweiten Anschluss (64; 264) begrenzter Leistungskanal einen elektrischen Dipol bildet, der an dem zweiten Verbindungsanschluss (64; 264) in Reihe zu der ersten Spannungsquelle (244) angeschlossen ist,
der Leistungstransistor (58; 258) eine Verlaufscharakteristik eines elektrischen Stroms aufweist, der den Leistungskanal abhängig von einer Differenzspannung zwischen dem ersten und dem zweiten Verbindungsanschluss (62, 64; 262; 264) durchströmt, wobei die elektrische Differenzspannung gleich einer elektrischen Spannung des ersten Anschlusses (62; 262) minus der elektrischen Spannung des zweiten Anschlusses (64; 264) ist, und der den Leistungskanal durchströmende elektrische Strom eine positive Richtung hat, wenn er von dem ersten Verbindungsanschluss (62; 262) zu dem zweiten Verbindungsanschluss (64; 264) fließt,
die Verlaufscharakteristik des Leistungstransistors (58; 258) eine erste Zone (118) inverser Polarisierung, in der die elektrische Spannung und der elektrische Strom eine selbe negative Richtung haben und der den Kanal durchströmende Strom keine Begrenzung aufweist, und eine zweite Zone (120) der unidirektionalen Strombegrenzung in Durchlassleitung aufweist, in der die elektrische Differenzspannung und der elektrische Strom die gleiche Richtung aufweisen und positiv sind und der elektrische Strom, der durch den Leistungskanal strömt, ab einer Stromschwelle strombegrenzt ist,
bei dem:
der Feldeffektleistungstransistor (58; 258) ein Feldeffekttransistor ist, der in der Familie der Transistoren JFET und MOS umfasst ist und dessen Halbleitersubstrat aus einem Material mit großem Bandabstand, insbesondere Silizium, Siliziumkarbid, Galliumnitrit GaN und Diamant, vorzugsweise aus Silizium oder Siliziumkarbid hergestellt ist,
der Feldeffektleistungstransistor (58; 258) an die erste Spannungsquelle mit umgekehrter Polarität in einer Konfiguration angeschlossen ist, in der die Differenzspannung des Leistungstransistors (58; 258) und die elektromotorische Kraft der ersten Spannungsquelle (244) entgegengesetzt sind, wenn der erste Versorgungszweig normal arbeitet, und
wenn ein Fehler an der ersten Spannungsquelle (244) auftritt, die elektromotorische Kraft der ersten Spannungsquelle (244) kleiner als die elektromotorische Kraft der zweiten Spannungsquelle (246) ist, der Feldeffektleistungstransistor (58; 258) in der zweiten Zone der unidirektionalen Strombegrenzung arbeitet und der erste Versorgungszweig (12; 212) gegenüber dem zweiten Versorgungszweig (14; 214) als Empfänger arbeitet.

2. Elektrisches Versorgungssystem nach Anspruch 1, bei dem die Differenzspannung zwischen der elektromotorischen Kraft der zweiten Spannungsquelle (246) und der elektromagnetischen Kraft der fehlerhaften ersten Spannungsquelle (244) größer oder gleich 20 Volt ist.

3. Elektrisches Versorgungssystem nach einem beliebigen der Ansprüche 1 oder 2, bei dem das Verhältnis der elektromotorischen Kraft der ersten fehlerhaften Spannungsquelle (244) zu der elektromotorischen Kraft der zweiten Spannungsquelle (246) kleiner oder gleich 90% ist.

4. Elektrisches Versorgungssystem nach einem beliebigen der Ansprüche 1 bis 3, bei dem der Leistungstransistor (58; 258) ein VJFET Transistor ist, dessen Substrat aus Siliziumkarbid besteht.

5. Elektrisches Versorgungssystem nach einem beliebigen der Ansprüche 1 bis 3, bei dem der Strombegrenzer (56) umfasst:
den Feldeffektleistungstransistor (58), der eine Drainelektrode (D), eine Sourceelektrode (S) und eine Gateelektrode (G) zur Steuerung eines Sättigungsstroms aufweist,
einen Bildstromsensor (322), der geeignet ist, einen Bildstrom zu liefern, der repräsentativ für den Leistungsstrom ist, der den Leistungskanal des Leistungstransistors (58) durchströmt,
einen Temperatursensor, (324), der repräsentativ für eine an dem Leistungstransistor (58) herrschende Temperatur ist,
eine Steuereinheit (306) des Strombegrenzers, die geeignet ist, den Leistungstransistor (58) abhängig von Messparametern zu steuern, die in der Gesamtheit umfasst ist, die von der durch den Temperatursensor (324) gemessene Temperatur und den von dem Stromsensor (322) gemessenen Bildstrom gebildet ist.

6. Elektrisches Versorgungssystem nach einem beliebigen der Ansprüche 1 bis 5, bei dem der Leistungstransistor (58) ein oder mehrere Elementarleistungstransistoren (558; 602; 672) umfasst, wobei jeder Elementarleistungstransistor (558; 602; 672) umfasst:
ein Substrat (604) eines ersten Leitfähigkeitstyps, das eine erste untere Fläche (606) und eine erste obere Fläche (608) aufweist,
eine Drainelektrode (610) in Kontakt mit der ersten unteren Fläche (606) des Substrats (604);
einen ersten Halbleiterbereich (612) des ersten Leitfähigkeitstyps, der eine zweite unter Fläche (614), die auf der ersten oberen Fläche des Substrats (604) angeordnet ist, und eine zweite obere Fläche (616) aufweist,
einen zweiten und dritten Halbleiterbereich (618, 620) eines zweiten Leitfähigkeitstyps, teilweise vergraben, die im Inneren des ersten Halbleiterbereichs (612) unter der zweiten oberen Fläche (616) angeordnet sind und im Inneren des ersten Bereichs (612) einen vertikalen Kanal (622) begrenzen,
einen vierten Halbleiterbereich (624) des ersten Leitfähigkeitstyps, als Oberflächengate, der zentral, teilweise und jeweils eine dritte obere Fläche (626) und eine vierte obere Fläche (628) des zweiten und dritten Bereichs (618, 620) abdeckt, wobei der vierte Bereich (624) einen Seitenkanal (630) bildet,
einen fünften Halbleiterbereich (632) des zweiten Leitfähigkeitstyps, der zentral und teilweise eine fünfte obere Fläche (634) des vierten Halbleiterbereichs (624) bedeckt,
eine erste Steuergateelektrode (636), die an der Oberfläche des fünften Bereichs (624) angeordnet ist,
mindestens eine Kontaktzone (640, 642), die unter der fünften oberen Fläche (634) in einer nicht von dem fünften Bereich (624) bedeckten Zone angeordnet ist, und
mindestens eine Sourceelektrode (646, 644), die auf der mindestens einen Kontaktzone (640, 642) angeordnet ist, und
eine zweite Gateelektrode (652, 654), die, sei es auf einer sechsten oberen Fläche (646), sei es auf einer siebenten oberen Fläche (656, 658) in einer nicht von dem vierten Halbleiterbereich (624) bedeckten Zone angeordnet ist.

7. Versorgungssystem nach Anspruch 6, **dadurch gekennzeichnet, dass** der Leistungstransistor (602) umfasst:
eine zweite Gateelektrode (652) und eine dritte Gateelektrode (654), die jeweils auf der sechsten oberen Fläche (656) und der siebenten oberen Fläche (658) in den nicht von dem vierten Halbleiterbereich (624) bedeckten Zonen angeordnet sind,
die zwei Kontaktzonen (640, 642), die beidseitig des vertikalen Kanals (622) unter der fünften oberen Fläche (634) in den nicht von dem fünften Bereich (632) bedeckten Zonen angeordnet sind,
zwei Sourceelektroden (644, 646), die jeweils auf einer unterschiedlichen Kontaktzone (640, 642) angeordnet sind.

8. Elektrisches Versorgungssystem nach Anspruch 7, **dadurch gekennzeichnet, dass** die zweite Gateelektrode (652) auf dem zweiten Halbleiterbereich (618) angeordnet ist, der Leistungstransistor (672) eine einzige Soruceelektrode (678) und eine einzige Kontaktzone (642) der Sourceelektrode umfasst und die einstückige Sourceelektrode (678) sowohl die Kontaktzone (642) als auch eine nicht von dem vierten Halbleiterbereich (624) bedeckten Zone des dritten Halbleiterbereichs (620) bedeckt.

9. Verfahren zum Schützen eines elektrischen Versorgungssystems (2; 202) mit Hilfe eines Strombegrenzers (56; 256), wobei das elektrische Versorgungssystem (2; 202) nach Anspruch 1 ausgebildet ist, wobei das Verfahren umfasst:
einen ersten Schritt (804), bei dem, wenn der erste Versorgungszweig (12; 212) normal arbeitet, der Leistungstransistor (58; 258) in der ersten Zone (118) in inverser Polarisierung ohne Begrenzung des Stroms arbeitet,
einen zweiten Schritt (806), bei dem, wenn ein Fehler an der ersten Spannungsquelle (244) des ersten Versorgungszweigs (12; 212) auftritt, der Leistungstransistor (58; 258) in der zweiten Zone (120) im Durchlass-Modus mit einer Strombegrenzung ab einem Schwellenwert des Stroms arbeitet.

10. Verfahren zum Schutz eines elektrischen Versorgungssystems nach Anspruchs 9, wobei das elektrische Versorgungssystem (2; 212) nach Anspruch 6 ausgebildet ist, bei dem
bei dem ersten Schritt (804) das Gate (G) des Leistungstransistors (58) auf einen ersten Steuerspannungs-Referenzwert gesetzt wird, und
bei dem das Verfahren einen Schritt (810) vor dem zweiten Schritt (806) und nach dem ersten Schritt (804) umfasst, bei dem
der Sensor (322) des Bildstroms einen Strom misst, der für den den Leistungstransistor (58) durchströmenden Leistungsstrom repräsentativ ist,
wenn ein Fehler an dem ersten Versorgungszweig (12) auftritt, der Leistungsstrom und der Bildstrom ihre Richtung wechseln und wenn der Bildstrom einen ersten Auslöseschwellenwert übersteigt, die Steuereinheit (306) einen Befehl zum Legen der Gatespannung (G) des Leistungstransistors (58) auf einen zweiten Wert der Gatespannung schickt, um einen zweiten Sättigungswert des Leistungsstroms einzustellen,
wenn der erste Versorgungszweig (12) normal arbeitet, die Steuerspannung des Gates (G) auf dem ersten Steuerwert bleibt und der Leistungstransistor (58) in der ersten Zone (118) arbeitet.

11. Verfahren zum Schutz eines elektrischen Versorgungssystems nach Anspruchs 10, bei dem
bei dem Schritt (810) der Temperatursensor (324) die Temperatur misst und der Stromsensor (322) den Bildstrom misst,
wenn ein Fehler an der ersten Spannungsquelle (844) des ersten Versorgungszweigs (12; 212) auftritt, der Leistungsstrom und der Bildstrom ihre Richtung umkehren und wenn die Temperatur steigend einen ersten Auslöseschwellenwert hinsichtlich der Temperatur übersteigt und/oder wenn der Bildstrom steigend einen ersten Auslöseschwellenwert hinsichtlich des Bildstroms übersteigt, die Steuereinheit (306) einen Befehl schickt, die Spannung des Gates (G) des Leistungstransistors (58) auf einen konservativen Steuerspannungswert in Bezug auf den Zustand des Überschreitens des Paares, das durch die erste Auslöseschwelle hinsichtlich des Bildstroms und die erste Auslöseschwelle hinsichtlich der Temperatur gebildet wird, zu setzen,
wobei der konservative Wert der Steuerspannung der Spannungswert des zweiten oder des dritten Steuerspannungswerts ist, der einem Wert des kleinsten Sättigungsstroms entspricht, wenn die erste Auslöseschwelle hinsichtlich des Bildstroms überschritten wird,
wobei der konservative Wert der Steuerspannung gleich dem dritten Wert der Steuerspannung entspricht, wenn allein die erste Auslöseschwelle hinsichtlich der Temperatur überschritten wird.

12. Verfahren zum Schützen eines elektrischen Versorgungssystems nach Anspruchs 11, bei dem
wenn kein Strom in dem Leistungstransistor (58) fließt und der Stromsensor (322) davon einen Bildwert entsprechend einer Vorspannung liefert, der Temperatursensor (324) die Überwachung des Bildstroms verfolgt, und
wenn eine Stromumkehr von dem Stromsensor detektiert wird, die ein Umschwenken der Funktionsweise des Begrenzers (56) von der ersten Zone (118) in die zweite Zone 120 repräsentiert, die Steuerspannung des vollständigen Unterdrückens des Fließens des Leistungsstroms in dem Leistungstransistor (58) gelöscht wird.

## Claims

1. An electrical power supply system, capable of supplying an electrical charge (4; 204) with a predetermined power supply current, comprising a first supply branch (12; 212) and a second supply branch (14; 214) connected in parallel,
the first supply branch (12; 212) comprising, connected in series, a first voltage source (244) and a current limiter (56; 256), and the second supply branch (14; 214) comprising a second voltage source (246),
the first voltage source (244) and the second voltage source (246) each having, when they operate normally, a same electromotive force whereof the polarization direction and the amplitude are identical to the polarization direction and the amplitude of the supply voltage,
the current limiter (56; 256) comprising a field effect power transistor (58; 258) with a first electrical connection terminal (62; 262) and a second electrical connection terminal (64; 264) and whereof a power channel defined between the first terminal (62; 262) and the second terminal (64; 264) forms an electric dipole connected in series to the first voltage source (244) at the second connection terminal (64; 264),
the power transistor (58; 258) having an evolution characteristic of an electrical current passing through the power channel as a function of a differential electrical voltage between the first and second connection terminals (62, 64; 262, 264), the differential electrical voltage being equal to an electrical voltage of the first terminal (62, 262) minus an electrical voltage of the second terminal (64; 264) and the electrical current passing through the power channel having a positive direction when it goes from the first connection terminal (62; 262) toward the second connection terminal (64; 264),
the evolution characteristic of the power transistor (58, 258) comprising a first inverse polarization area (118), wherein the electrical voltage and the current have the same negative direction and the current passing through the channel is not limited, and a second single-direction current limiting area (120), in direct conduction, in which the differential electrical voltage and the electrical current have the same direction and are positive and the electrical current passing through the power channel is current-limited from a current threshold,
wherein
the field effect power transistor (58; 258) is a field effect transistor comprised in the family of JFET and MOS transistors, and whereof the semiconducting substrate is made from a material with a wide band gap comprising silicon, silicon carbide, gallium nitride GaN and diamond, preferably silicon or silicon carbide,
the field effect power transistor (58; 258) is connected to the first voltage source (244) with an inverse polarization, in a configuration where the voltage differential of the power transistor (58; 258) and the electromotive force of the first voltage source (244), when the first supply branch operates normally, are opposite, and
the first supply branch (12; 212) is configured so that, when a defect occurs on the first voltage source (244), the electromotive force of the first voltage source (244) is lower than the electromotive force of the second voltage source (246), the field effect power transistor (58; 258) functions in the second single direction current limiting area and the first supply branch (12; 212) operates as a receiver with respect to the second supply branch (14; 214).

2. The electrical power supply system according to claim 1, wherein the voltage difference between the electromotive force of the second voltage source (246) and the electromotive force of the defective first voltage source (244) is greater than or equal to 20 V.

3. The electrical power supply system according to any one of claims 1 or 2, wherein the ratio of the electromotive force of the defective first voltage source (244) to the electromotive force of the second voltage source (246) is less than or equal to 90%.

4. The electrical power supply system according to any one of claims 1 to 3, wherein the power transistor (58; 258) is a transistor of the VJFET type whereof the substrate is made from silicon carbide.

5. The electrical power supply system according to any one of claims 1 to 4, wherein the current limiter (56) comprises:
the field effect power transistor (58) having a drain electrode (D), a source electrode (S), and a gate electrode (G) for controlling a saturation current,
an image current sensor (322) capable of providing an image current that is representative of the power current passing through the power channel of the power transistor (58),
a sensor (324) for a temperature that is representative of a temperature prevailing within the power transistor (58),
a control unit (306) of the current limiter capable of commanding the power transistor (58) as a function of measurement parameters comprised in the set made up of the temperature measured by the temperature sensor (324) and the image current measured by the current sensor (322).

6. The electrical power supply system according to any one of claims 1 to 5, wherein the power transistor (58) comprises one or more basic power transistors (558; 602; 672), each basic power transistor (558; 602; 672) comprising:
a substrate (604) of a first conductivity type having a first lower face (606) and a first upper face (608),
a drain electrode (610) in contact with the first lower face (606) of the substrate (604),
a first semiconducting region (612) of the first conductivity type having a second lower face (614) arranged on the first upper face of the substrate (604), and a second lower face (616),
second and third semiconducting regions (618, 620) of a second conductivity type, partially buried, arranged inside the first semiconducting region (612) under the first upper face (616) and defining a vertical channel (622) inside the first region (612),
a fourth semiconducting region (624) of the first conductivity type, with a surface gate, centrally, partially and respectively covering a third (626) and fourth (628) upper face of the second and third regions (618, 620), the fourth region (624) forming a side channel (630),
a fifth semiconducting region (632) of the second conductivity type centrally and partially covering a fifth upper face (634) of the fourth semiconducting region (624),
a first control gate electrode (636) positioned on the surface of the fifth region (624),
at least one contact area (640, 642) positioned under the fifth upper face (634) in an area not covered by the fifth region (624), and
at least one source electrode (646, 644) positioned on the at least one contact area (640, 642), and
a second gate electrode (652, 654) positioned either on a sixth upper face (656), or on a seventh upper face (658) in an area not covered by the fourth semiconducting region (624).

7. The electrical power supply system according to claim 6, wherein the power transistor (602) comprises
a second gate electrode (652) and a third gate electrode (654) respectively positioned on the sixth upper face (656) and the seventh upper face (658) in areas not covered by the fourth semiconducting region (624),
the two contact areas (640, 642), positioned on either side of the vertical channel (622), under the fifth upper face (634) in areas not covered by the fifth region (632),
two source electrodes (644, 646) each positioned on a different contact area (640, 642).

8. The electrical power supply system according to claim 7, wherein the second gate electrode (652) is positioned on the second semiconducting region (618), the power transistor (672) comprises a single source electrode (678) and a single contact area (642) of the source electrode, and the source electrode (678), in a single piece, covers both the contact area (642) and an area of the third semiconducting region (620) not covered by the fourth semiconducting region (624).

9. A method for protecting a power supply system (2; 202) using a current limiter (56; 256), the power supply system (2; 202) being conform to claim 1, the method comprising : a first step (804) in which, when the first supply branch (12; 212) operates normally, the power transistor (58; 258) operates in the first area (118), in inverse polarization without current limitation,
a second step (806) in which, when a defect occurs on the first voltage source (244) of the first supply branch (12; 212), the power transistor (58; 258) operates in the second area (120), in direct conduction with current limitation from a current threshold value.

10. A method for protecting a power supply system according to claim 9, the power supply system (2; 202) being conform to claim 6, wherein in the first step (804), the gate (G) of the power transistor (58) is set to a first reference control voltage value, and
wherein the method comprises a step (810), before the second step (806) and after the first step (804), wherein
the image current sensor (322) measures the current representative of the power current passing through the power transistor (58),
when a defect occurs on the first supply branch (12), the power current and the image current invert their directions and when the image current exceeds a first activation threshold value, the control unit (306) sends a command to set the voltage of the gate (G) of the power transistor (58) to a second gate voltage value so as to adjust a second saturation value of the power current,
when the first supply branch (12) operates normally, the control voltage of the gate (G) remains at the first control value and the power transistor (58) operates in a first area (118).

11. The method for protecting a power supply system according to claim 10, wherein
in step (810), the temperature sensor (324) measures the temperature and the current sensor (322) measures the image current,
when a defect occurs on the first voltage source (844) of the first supply branch (12; 212), the power current and the image current invert their directions and when the temperature exceeds a first temperature activation threshold value while increasing and/or when the image current exceeds a first image current activation threshold value while increasing, the control unit (306) sends a command to set the voltage of the gate (G) of the power transistor (58) to a conservative control voltage value relative to the state exceeding the pair formed by the first image current activation threshold and the first temperature activation threshold,
the value of the conservative control voltage being the voltage value from among the second and third control voltage values that corresponds to the smallest saturation current value when the first image current activation threshold and the first temperature activation threshold are exceeded,
the value of the conservative control voltage being equal to the second control voltage value when only the first image current activation threshold is exceeded,
the value of the conservative control voltage being equal to the third control voltage value when only the first temperature activation threshold is exceeded.

12. The method for protecting a power supply system according to claim 11, wherein
when no current circulates in the power transistor (58) and the current sensor (322) provides an image value thereof corresponding to a bias, the temperature sensor (324) continues to monitor the image current, and
when an inversion of the current is detected by the current sensor that is representative of the switch of an operation of the limiter (56) from the first area (118) into the second area (120), the control voltage completely inhibiting circulation of the power current in the power transistor (58) is eliminated.
